(19) **Europäisches Patentamt**
**European Patent Office**
**Office européen des brevets**

(11) **EP 4 693 396 A1**

(12) **EUROPEAN PATENT APPLICATION**
published in accordance with Art. 153(4) EPC

(43) Date of publication:
**11.02.2026 Bulletin 2026/07**

(21) Application number: **24780848.8**

(22) Date of filing: **29.03.2024**

(51) International Patent Classification (IPC):
*H01L 23/36* (2006.01)   *C08K 3/013* (2018.01)
*C08L 83/04* (2006.01)   *H05K 7/20* (2006.01)

(52) Cooperative Patent Classification (CPC):
**C08K 3/013; C08L 83/04; H01L 23/36; H05K 7/20**

(86) International application number:
**PCT/JP2024/013141**

(87) International publication number:
**WO 2024/204753 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.03.2023 JP 2023059627**

(71) Applicant: **Sekisui Chemical Co., Ltd.
Osaka-shi, Osaka 530-8565 (JP)**

(72) Inventors:
• **KUROO, Kenta**
  **Mishima-gun, Osaka 618-0021 (JP)**
• **ASHIBA, Kouji**
  **Saitama-city, Saitama 338-0837 (JP)**

(74) Representative: **Ter Meer Steinmeister & Partner
Patentanwälte mbB
Nymphenburger Straße 4
80335 München (DE)**

(54) **THERMALLY CONDUCTIVE SHEET AND METHOD FOR MANUFACTURING SAME**

(57)    A heat conductive sheet including a heat conductive layer including a polymer matrix and a heat conductive filler, and an acrylic pressure-sensitive adhesive layer provided on the surface of the heat conductive layer, wherein the acrylic pressure-sensitive adhesive layer has a reactive double bond.

EP 4 693 396 A1

**Description**

SAME

Technical Field

The present invention relates to a heat conductive sheet, and the method for manufacturing the same.

Background Art

In recent years, in conjunction with increase of wiring density of multilayer wiring boards, increase of wiring density in semiconductor packages, increase of mounting density of electronic components, and increase of heat generation per unit area due to the increased integration of semiconductor devices and the like, improvement of heat dissipation is desired for semiconductor packages. Semiconductor packages are known to have a heat dissipating material that is disposed between a heating element, such as a semiconductor chip, and a heat dissipating element, which is also referred to as a heat spreader, and tightly adhered thereto, to dissipate heat. Conventionally, heat conductive grease is widely used as a heat dissipating material placed between a semiconductor chip and a heat spreader for use.
Semiconductor packages are generally heated to a certain temperature or higher during use or the like. Since members such as a substrate, a semiconductor chip, and a heat spreader each have a different coefficient of thermal expansion, they may warp when heated. Recently, the gap due to the warpage has been widened in conjunction with an increase in size of the chip. The heat conductive grease is unable to adjust to such warpage, resulting in defects where a gap is formed. Thus, the use of a heat conductive sheet instead of the heat conductive grease has been studied.
The heat conductive sheet to be used in the above-described application is required to have enhanced flexibility to improve adjustability to warpage while enhancing heat dissipation. However, the heat conductive sheet might peel from the semiconductor chip or heat spreader due to a failure to adjust to the warpage as with the heat conductive grease because the enhancement of both heat dissipation and flexibility results in deteriorated adhesion to peripheral members. Therefore, in PTL 1, for example, an attempt to suppress peeling from a semiconductor chip or a heat spreader has been made by blending liquid polybutene, an acrylic acid ester-based polymer, an ethylene/$\alpha$-olefin copolymer, a hot-melt adhesive, or the like into a heat conductive sheet to thereby increase tack force.

Citation List

Patent Literature

PTL1: JP 7067571 B(2)

Summary of Invention

Technical Problem

In general, semiconductor packages are manufactured through a reflow process, which generally involves heating at high temperatures. Therefore, a heat conductive sheet placed between a semiconductor chip and a heat spreader for use is sometimes required to maintain adhesion to an adherend such as the semiconductor chip and the heater spreader even after being heated to high temperature.
When the tack force is merely improved as described PTL 1, however, the tack force decreases during heating at high temperatures in the reflow process or the like, causing a problem that peeling of the heat conductive sheet from the adherend occurs.
Accordingly, an object of the present invention is to provide a heat conductive sheet capable of being adhered to an adherend and preventing the sheet from peeling from the adherend even after heating at high temperatures, such as reflow.

Solution to Problem

As a result of intensive studies, the present inventors have found that, in a heat conductive sheet comprising a heat conductive layer containing a polymer matrix and a heat conductive filler, and an acrylic pressure-sensitive adhesive layer provided on the surface of the heat conductive layer, the above object can be achieved by including a reactive double bond in the acrylic pressure-sensitive adhesive layer, thereby completing the following present invention.
Specifically, the present invention provides [1] to [14] below.

[1] A heat conductive sheet comprising a heat conductive layer comprising a polymer matrix and a heat conductive filler, and an acrylic pressure-sensitive adhesive layer provided on a surface of the heat conductive layer, the acrylic pressure-sensitive adhesive layer comprising a reactive double bond.

[2] The heat conductive sheet according to [1], wherein an intensity ratio A/B of a peak intensity A of C=C stretching vibration to a peak intensity B of C=O stretching vibration is 0.2 or more in a Raman spectrum of the acrylic pressure-sensitive adhesive layer.

[3] The heat conductive sheet according to [1] or [2], wherein the polymer matrix is organopolysiloxane.

[4] The heat conductive sheet according to any one of [1] to [3], wherein the heat conductive layer comprises an anisotropic filler oriented in a thickness direction of the heat conductive layer.

[5] The heat conductive sheet according to any one of [1] to [4], wherein the surface of the heat conductive layer is a slice surface.

[6] The heat conductive sheet according to any one of [1] to [5], wherein the acrylic pressure-sensitive adhesive layer permeates into the heat conductive layer.

[7] A method for producing a heat conductive sheet, comprising:

mixing at least a curable polymer composition and a heat conductive filler to obtain a mixed composition;
curing the mixed composition by heating to obtain a cured product; and
applying a pressure-sensitive adhesive to a surface of the cured product,
the pressure-sensitive adhesive being an acrylic pressure-sensitive adhesive comprising a reactive double bond.

[8] The method for producing a heat conductive sheet according to [7], comprising heating the mixed composition to obtain a formed product, slicing the formed product, and forming the cured product into a sheet shape.

[9] The method for producing a heat conductive sheet according to [7] or [8], wherein a compatible substance is further mixed in addition to the curable polymer composition and the heat conductive filler to obtain the mixed composition, and at least a part of the compatible substance is volatilized by the heating.

[10] The method for producing a heat conductive sheet according to any one of [7] to [9], comprising allowing the applied pressure-sensitive adhesive to permeate into the cured product.

[11] An adhesion method comprising: a tight adhesion step of disposing the heat conductive sheet according to any one of [1] to [6] between a semiconductor chip and a heat spreader to tightly adhere the sheet thereto; and an adhesion step of bonding the semiconductor chip and the heat spreader, which are heated to 200°C or more after the tight adhesion step.

[12] The adhesion method according to [11], wherein in the tight adhesion step, the heat conductive sheet is sandwiched between the semiconductor chip and the heat spreader and then pressurized at 50°C or more and 200°C or less to be tightly adhered.

[13] The adhesion method according to [11] or [12], wherein the adhesion step is performed in a non-pressurized state.

[14] Use of a heat conductive sheet for adhering a semiconductor chip and a heat spreader in a reflow process, the heat conductive sheet comprising a heat conductive layer comprising a polymer matrix and a heat conductive filler, and an acrylic pressure-sensitive adhesive layer provided on a surface of the heat conductive layer, the acrylic pressure-sensitive adhesive layer comprising a reactive double bond.

Advantageous Effect of Invention

According to the present invention, it is possible to provide a heat conductive sheet capable of tightly adhering to an adherend and preventing the sheet from peeling from the adherend even after heating at high temperatures, such as a reflow process.

Brief Description of Drawings

[Fig. 1] Fig. 1 is a schematic view illustrating a thermal resistance measuring machine.
[Fig. 2] Fig. 2 is a schematic view illustrating a method of measuring die shear strength.

Description of Embodiments

[Heat Conductive Sheet]

A heat conductive sheet of the present invention includes a heat conductive layer comprising a polymer matrix and a heat conductive filler, and an acrylic pressure-sensitive adhesive layer provided on the surface of the heat conductive layer. Hereinafter, the heat conductive sheet is described in detail.

(Acrylic Pressure-Sensitive Adhesive Layer)

In the present invention, the acrylic pressure-sensitive adhesive layer has a reactive double bond. Even when the heat conductive sheet is tightly adhered to an adherend, such as a heat spreader or semiconductor chip, and heated to a high temperature, for example, in the reflow process, the heat conductive sheet can remain tightly adhered when the acrylic pressure-sensitive adhesive layer has a reactive double bond, preventing it from peeling from the adherend. Even when used in an environment at a relatively high temperature of, for example, about 150°C in practical use, the heat conductive sheet can maintain high adhesion.

In general, the acrylic pressure-sensitive adhesive is known to have a significantly reduced adhesive force when heated at a high temperature. In the present invention, however, the acrylic pressure-sensitive adhesive layer has reactive double bonds, which can maintain or improve the adhesive force to an adherend contrary to properties of conventional, general acrylic pressure-sensitive adhesives. Although the principle is not clear, it is presumed that the reactive double bonds in the acrylic pressure-sensitive adhesive layer react by heating to bond to, for example, an adherend, or improve the mechanical strength of the pressure-sensitive adhesive layer by crosslinking between the reactive double bonds, and further, in some cases, react with, for example, unreacted hydrosilyl groups in the organopolysiloxane forming the polymer matrix, all of which act in combination to improve the adhesion.

The acrylic pressure-sensitive adhesive layer is formed from an acrylic pressure-sensitive adhesive. The acrylic pressure-sensitive adhesive may contain an acrylic-based polymer as a base resin of the pressure-sensitive adhesive, and the acrylic-based polymer may have the above-described reactive double bond. The acrylic pressure-sensitive adhesive layer can exhibit pressure-sensitive adhesive properties by containing an acrylic-based polymer. In addition, it is considered that the acrylic-based polymer having the reactive double bond dramatically improves the mechanical strength of the pressure-sensitive adhesive layer by crosslinking of the reactive double bonds.

In the acrylic pressure-sensitive adhesive layer of the present invention, an intensity ratio A/B of a peak intensity A of C=C stretching vibration to a peak intensity B of C=O stretching vibration in a Raman spectrum is preferably 0.2 or more. Herein, the peak intensity A refers to a peak generated by a reactive double bond (C=C double bond). The peak intensity B refers to a peak generated by C=O bond contained in the acrylic-based polymer. Therefore, the intensity ratio A/B of the peak intensity A to the peak intensity B can be an index indicating the proportion of the reactive double bond in the acrylic-based polymer.

The acrylic-based pressure-sensitive adhesive layer has a sufficient amount of reactive double bonds when the intensity ratio A/B is 0.2 or more, thus maintaining proper adhesion to an adherend even when heated to a high temperature, for example, in a reflow process in a state of being tightly adhered to the adherend.

The intensity ratio A/B is more preferably 0.3 or more, still more preferably 0.4 or more, and even more preferably 0.5 or more. The intensity ratio A/B is, for example, 1.0 or less, preferably 0.8 or less, and more preferably 0.7 or less, although not limited thereto.

Note that the peak of C=O stretching vibration is typically a peak appearing around the wavenumber of 1720 cm$^{-1}$. The peak of the C=C stretching vibration is typically a peak appearing around the wavenumber of 1636 cm$^{-1}$. However, these peaks may slightly shift due to the structure of the acrylic-based polymer or the like.

The acrylic-based polymer to be used in the acrylic-based pressure-sensitive adhesive layer may contain an acrylic-based polymer having a reactive double bond (reactive double bond-containing acrylic-based polymer). The reactive double bond-containing acrylic-based polymer preferably has a reactive double bond in a side chain. The reactive double bond is a saturated carbon-carbon double bond that does not form an aromatic ring, which is typically composed of a group having a structure represented by $H_2C = CH\text{-}*$ or $H_2C = CCH_3\text{-}*$ (where * represents a bonding). Specific examples thereof include a vinyl group, an acryloyl group, and a methacryloyl group.

The reactive double bond-containing acrylic-based polymer may also have functional group(s) such as hydroxy group(s), carboxyl group(s), epoxy group(s), or amino group(s) in the side chain in addition to the group having the reactive double bond, and preferably has at least one of hydroxy group(s) or carboxyl group(s) in a side chain, still more preferably both hydroxy group(s) and carboxyl group(s).

The weight-average molecular weight of the reactive double bond-containing acrylic-based polymer is, for example, about 100,000 or more and 1,200,000 or less, preferably about 200,000 or more and 1,000,000 or less, although not limited thereto. Note that the weight-average molecular weight is measured by gel permeation chromatography (GPC) and determined in terms of polystyrene. The molecular weight can be adjusted to adjust the solid content concentration and viscosity of the pressure-sensitive adhesive containing an organic solvent described later. Specifically, when it is desired to adjust the viscosity to be low while increasing the solid content concentration, the molecular weight may be reduced. In addition, when it is desired to adjust the viscosity to be high while reducing the solid content concentration, the molecular weight may be increased.

The reactive double bond-containing acrylic-based polymer can be obtained, for example, by reacting an acrylic polymer having functional group(s) such as hydroxy group(s), carboxyl group(s), epoxy group(s), or amino group(s) in a side chain (hereinafter also referred to as an acrylic polymer (X)) with a reactive double bond-containing compound having reactive group(s) that reacts with the functional group and a reactive double bond (hereinafter also referred to as a reactive double bond-containing compound (Y)).

The acrylic polymer (X) may contain a (meth)acrylate-derived structural unit, typically an alkyl (meth)acrylate-derived structural unit as the main component. More specifically, examples of the acrylic polymer (X) include a copolymer of an alkyl (meth)acrylate and a functional group-containing monomer, and a copolymer of an alkyl (meth)acrylate, a functional group-containing monomer, and another monomer other than the above.

Note that (meth)acrylate is used as a term meaning one or both of acrylate and methacrylate, and the same applies to another similar term.

The alkyl (meth)acrylate is an ester of (meth)acrylic acid and alkyl alcohol. The alkyl group in the alkyl (meth)acrylate may be linear, may have a branched structure, or may have a cyclic structure.

Examples of the alkyl (meth)acrylate include methyl (meth)acrylate, ethyl (meth)acrylate, propyl (meth)acrylate, n-butyl (meth)acrylate, isobutyl (meth)acrylate, tert-butyl (meth)acrylate, 2-ethylhexyl (meth)acrylate, n-octyl (meth)acrylate, isooctyl (meth)acrylate, isononyl (meth)acrylate, isomyristyl (meth)acrylate, stearyl (meth)acrylate, cyclohexyl (meth)acrylate, and isobornyl (meth)acrylate.

The alkyl (meth)acrylate may be used alone or in combination with two or more thereof.

The alkyl (meth)acrylate is preferably an alkyl (meth)acrylate including an alkyl group having 1 to 12 carbon atoms, more preferably contains an alkyl acrylate including an alkyl group having 2 to 8 carbon atoms. The structural unit derived from the alkyl acrylate including an alkyl group having 2 to 8 carbon atoms may be a main component in the acrylic polymer (X), and may be, for example, 50% by mass or more, preferably 60% by mass or more and 95% by mass or less, and more preferably 70% by mass or more and 90% by mass or less in the acrylic polymer (X).

Examples of the functional group in the functional group-containing monomer include a carboxyl group, a hydroxy group, an amino group, and an epoxy group as described above, among which a carboxyl group and a hydroxy group are preferable. Examples of the monomer containing a carboxyl group include (meth)acrylic acid and crotonic acid, among which (meth)acrylic acid is more preferable.

Examples of the monomer containing a hydroxy group include a (meth)acrylate having a hydroxy group, such as 2-hydroxyethyl (meth)acrylate, 2-hydroxypropyl (meth)acrylate, 3-hydroxypropyl (meth)acrylate, 2-hydroxybutyl (meth)acrylate, 4-hydroxybutyl (meth)acrylate, 5-hydroxypentyl (meth)acrylate, and 6-hydroxyhexyl (meth)acrylate, and allyl alcohol, among which a (meth)acrylate having a hydroxy group such as 2-hydroxyethyl (meth)acrylate is preferable.

The structural unit derived from the functional group-containing monomer in the acrylic polymer (X) is, for example, about 1% by mass or more and 35% by mass or less, preferably 5% by mass or more and 30% by mass or less, and more preferably 10% by mass or more and 25% by mass or less.

The functional group-containing monomer may be used alone or in combination with two or more thereof.

Examples of the other monomer include a monomer other than the alkyl (meth)acrylate and the functional group-containing monomer described above, which are not limited as long as the monomer is copolymerizable with the alkyl (meth)acrylate and the functional group-containing monomer. Specific examples thereof include a styrene derivative such as styrene, $\alpha$-methylstyrene, p-methylstyrene, p-chlorostyrene, and divinylbenzene; a compound having a vinyl ester group such as vinyl acetate and vinyl propionate, N-vinylpyrrolidone, N-vinylmorpholine, (meth)acrylonitrile, N-cyclohexylmaleimide, N-phenylmaleimide, N-laurylmaleimide, N-benzylmaleimide, n-propylvinyl ether, n-butylvinyl ether, isobutylvinyl ether, and tert-butylvinyl ether. The other monomer may be used alone or in combination with two or more thereof.

The reactive double bond-containing compound (Y) is a compound having a reactive group that reacts with the above-described functional group and a reactive double bond. Examples of the reactive group include an isocyanate group, an epoxy group, a carboxyl group, and a hydroxy group, among which an isocyanate group and an epoxy group are preferable, and an isocyanate group is more preferable.

The content of the reactive double bond contained in the acrylic pressure-sensitive adhesive layer can be adjusted by the amount of the functional group included in the acrylic polymer (X) and the proportion of the functional group that reacts with the reactive double bond-containing compound (Y). The amount of the functional group contained in the acrylic polymer (X) can be adjusted by the proportion of the functional group-containing monomer used in synthesizing the acrylic polymer (X).

The acrylic-based polymer contained in the acrylic pressure-sensitive adhesive layer may comprise a reactive double bond-containing acrylic-based polymer or may contain an acrylic-based polymer having no reactive double bond in addition to the reactive double bond-containing acrylic-based polymer. Examples of the acrylic-based polymer having no reactive double bond include the above-described acrylic polymer (X).

The acrylic pressure-sensitive adhesive may contain, in addition to the acrylic-based polymer described above, a component generally blended in a pressure-sensitive adhesive and may appropriately contain additives such as a crosslinking agent, a tackifier, a filler, an antioxidant, an ultraviolet ray inhibitor, a plasticizer, and a viscosity modifier.

The acrylic pressure-sensitive adhesive layer may be provided on one surface of the heat conductive layer or on both surfaces of the heat conductive layer. As used herein, the one surface or both surfaces refer to a surface along the direction perpendicular to the thickness direction of the heat conductive layer, which is also referred to as a so-called main surface.

When the acrylic pressure-sensitive adhesive layer is provided on both surfaces of the heat conductive layer, the adhesion of both surfaces of the heat conductive sheet to adherends can be enhanced. Therefore, when used in a semiconductor application, the heat conductive sheet can tightly adhere to, for example, both a semiconductor chip and a heat spreader with a relatively high pressure-sensitive adhesive force. In addition, even when the heat conductive sheet is heated at a high temperature through a reflow process or the like in a state of being adhered to these components, it is easy to prevent the heat conductive sheet from peeling from both the semiconductor chip and the heat spreader.

The basis weight on each surface of the acrylic pressure-sensitive adhesive layer is, for example, 0.05 mg/cm$^2$ or more, preferably 0.1 mg/cm$^2$ or more, more preferably 0.2 mg/cm$^2$ or more, and still more preferably 0.3 mg/cm$^2$ or more, and is for example 1.0 mg/cm$^2$ or less, preferably 0.75 mg/cm$^2$ or less, more preferably 0.5 mg/cm$^2$ or less, and still more preferably 0.45 mg/cm$^2$ or less. The acrylic pressure-sensitive adhesive layer can secure a sufficient pressure-sensitive adhesive force to an adherend by setting the basis weight to a certain amount or more. In addition, the acrylic pressure-sensitive adhesive layer can prevent a thermal resistance value from decreasing, making it easier to secure good thermally conductive properties when the basis weight is a certain level or less.

The acrylic pressure-sensitive adhesive layer preferably permeates into the heat conductive layer. Typically, the acrylic pressure-sensitive adhesive layer may partially permeate into the heat conductive layer. As long as the acrylic pressure-sensitive adhesive layer can exhibit a pressure-sensitive adhesive force with respect to an adherend, the whole thereof may permeate into the heat conductive layer. The acrylic pressure-sensitive adhesive layer permeating into the heat conductive layer can reduce the amount of the pressure-sensitive adhesive present on the surface of the heat conductive layer, and thereby suppressing deterioration in thermally conductive properties by the acrylic pressure-sensitive adhesive layer.

In addition, the heat conductive sheet can maintain high adhesion, even when the pressure-sensitive adhesive permeates into the pressure-sensitive adhesive layer. Although the principle is not clear, it is presumed that the pressure-sensitive adhesive that permeates into the heat conductive sheet, which is generally, for example, compressed and then pressurized during use, oozes out to the surface to enhance the adhesion.

The acrylic pressure-sensitive adhesive layer can be permeated into cells formed by volatilization of volatile substances as will be described later, thereby allowing an appropriate amount of the acrylic pressure-sensitive adhesive layer to permeate the heat conductive layer.

In addition, the acrylic pressure-sensitive adhesive layer may be formed so as to cover the entirety of each surface of the heat conductive layer or may be formed so as to partially cover the heat conductive layer as long as the heat conductive layer can exert pressure-sensitive adhesive force to an adherend.

Note that the above-described cell is a space defined by the polymer matrix or the heat conductive filler in the heat conductive layer and a continuous space as a volatilization path of the volatile substance. Such continuity allows the pressure-sensitive adhesive to permeate into the heat conductive layer.

[Heat conductive Layer]

A heat conductive layer of the present invention includes a polymer matrix and a heat conductive filler. The polymer matrix is a matrix comprising an organic polymer, such as an elastomer and rubber, and is preferably a product formed by curing a liquid polymer composition (curable polymer composition) of a mixed system, such as a base resin and a curing agent. The curable polymer composition may comprise, for example, uncrosslinked rubber and a crosslinking agent, or may contain a monomer, a prepolymer or the like, and a curing agent or the like. In addition, the curing reaction may be room temperature curing or heat curing.

The polymer matrix is preferably organopolysiloxane. In the present invention, the use of organopolysiloxane can make the polymer matrix flexible after curing and enhance filling properties of a heat conductive filler. The organopolysiloxane is preferably silicone rubber. In addition, the organopolysiloxane is preferably curable silicone, and more preferably addition-reaction type silicone.

In the case of the addition-reaction type silicone, the curable polymer composition is composed of an alkenyl group-containing organopolysiloxane (base resin) and a hydrogenorganopolysiloxane (curing agent), and the polymer matrix may be obtained by curing these components. It is considered that the use of the addition-reaction type silicone makes the reactive double bond contained in the acrylic pressure-sensitive adhesive layer reacts with an unreacted hydrosilyl group by heating at high temperatures, for example, in a reflow process, thereby facilitating the enhancement of adhesion to an adherend. In particular, since the organopolysiloxane is a resin for use in a release layer, it has been common knowledge that the acrylic pressure-sensitive adhesive does not adhere to the silicone. However, as described above, it has been unexpected that the acrylic pressure-sensitive adhesive layer contains a reactive double bond, which increases the adhesion after a predetermined heating step.

As the rubber, various synthetic rubbers other than silicone rubber can be used. Specific examples thereof include acrylic rubber, nitrile rubber, isoprene rubber, urethane rubber, ethylene propylene rubber, styrene-butadiene rubber, butadiene rubber, fluororubber, and butyl rubber. When any of these rubbers is used, the synthetic rubber may be crosslinked or left uncrosslinked (that is, uncured) in the heat conductive sheet. Uncrosslinked rubber is used mainly in flow orientation.

When the synthetic rubber is crosslinked (that is, cured), the polymer matrix may be, as described above, a product obtained by curing a curable polymer composition comprising an uncrosslinked rubber comprising any of these synthetic rubbers and a crosslinking agent.

As the elastomer, a thermoplastic elastomer, such as a polyester-based thermoplastic elastomer or a polyurethane-based thermoplastic elastomer, or a thermosetting elastomer formed by curing a liquid polymer composition of a mixed system comprising a base resin and a curing agent can be used. The elastomer is, for example, a polyurethane-based elastomer formed by curing a polymer composition containing a polymer having a hydroxy group and isocyanate.

The polymer composition for forming the polymer matrix may be formed of an organic polymer alone or may be formed of an organic polymer and a plasticizer. The plasticizer is suitably used when synthetic rubber is used. When the plasticizer is contained, the flexibility of the uncrosslinked polymer matrix can thereby be enhanced. For example, when the polymer matrix is organopolysiloxane, silicone oil may be used as the plasticizer. In other words, the curable polymer composition may comprise a base resin and curing agent or may contain, a base resin, a curing agent, and a plasticizer.

The content of the polymer matrix, expressed in terms of a filling rate on a volume basis (volume filling rate), is preferably 15% by volume or more and 50% by volume or less, more preferably 17% by volume or more and 45% by volume or less, and still more preferably 20% by volume or more and 40% by volume or less, based on the total amount of the heat conductive sheet.

(Heat Conductive Filler)

The heat conductive filler contained in the heat conductive layer is preferably dispersed in and retained by the polymer matrix. Examples of the heat conductive filler include an anisotropic filler and a non-anisotropic filler, and it is preferable to use at least an anisotropic filler.

The anisotropic filler is preferably oriented in the thickness direction of the heat conductive sheet. As a result, the heat conductive layer tends to increase the thermally conductive properties. When the anisotropic filler is oriented in the thickness direction, its major axis direction need not be strictly parallel to the thickness direction. It is assumed that the anisotropic filler is oriented in the thickness direction even when the major axis direction is slightly inclined with respect to the thickness direction. Specifically, an anisotropic filler in which the major axis direction is inclined by less than 20° is also regarded as being oriented in the thickness direction, and such an anisotropic filler is assumed to be oriented in the thickness direction when it constitute the majority (for example, more than 60%, preferably more than 80% of the total number of anisotropic fillers) in the heat conductive sheet.

The content of the heat conductive filler is preferably 150 parts by mass or more and 3000 parts by mass or less, more preferably 200 parts by mass or more and 1800 parts by mass or less, and still more preferably 300 parts by mass or more and 1000 parts by mass or less, based on 100 parts by mass of the polymer matrix. When the content of the heat conductive filler is 150 parts by mass or more, a certain level of thermally conductive properties can be imparted to the heat conductive layer. When the content is 3000 parts by mass or less, the heat conductive filler can be properly dispersed in the polymer matrix. In addition, it is possible to prevent the viscosity of a mixed composition described later from becoming higher than necessary.

The volume filling rate of the heat conductive filler based on the total amount of the heat conductive layer is preferably 30% by volume or more and 85% by volume or less, more preferably 50% by volume or more and 83% by volume or less, and still more preferably 60% by volume or more and 80% by volume or less. When the volume filling rate is equal to or greater than the lower limit, a certain level of thermally conductive properties can be imparted to the heat conductive layer. Furthermore, a volume filling rate equal to or less than the upper limit facilitates the manufacture of the heat conductive layer.

(Anisotropic Filler)

The anisotropic filler is a filler having anisotropy in shape that can be oriented. Examples of the anisotropic filler include a fibrous material and a flake-like material. The anisotropic filler has a high aspect ratio, specifically an aspect ratio of more than 2, preferably 5 or more. When the aspect ratio is larger than 2, the anisotropic filler is easily oriented in the thickness direction, making it easy to increase the thermally conductive properties of the heat conductive layer in one direction such as the thickness direction. The upper limit of the aspect ratio is practically 100, although not limited thereto.

Note that the aspect ratio refers to a ratio of the length in the major axis direction to the length in the minor axis direction of the anisotropic filler. For a fibrous material, the aspect ratio means fiber length/size of the fiber, and for a flake-like material, the aspect ratio means length/thickness in the major axis direction of the flake-like material.

The content of the anisotropic filler in the heat conductive layer is preferably 10 parts by mass or more and 500 parts by mass or less, more preferably 30 parts by mass or more and 300 parts by mass or less, and still more preferably 50 parts by mass or more and 250 parts by mass or less, based on 100 parts by mass of the polymer matrix.

When the content of the anisotropic filler is 10 parts by mass or more, the thermally conductive properties are easily enhanced. When the content is 500 parts by mass or less, the viscosity of the mixed composition described later tends to be appropriate, and the orientation of the anisotropic filler becomes good. The dispersing ability of the anisotropic filler in the polymer matrix is also enhanced.

When the anisotropic filler is a fibrous material, the average fiber length is preferably 10 $\mu$m or more and 300 $\mu$m or less, more preferably 20 $\mu$m or more and 200 $\mu$m or less, and still more preferably 30 $\mu$m or more and 100 $\mu$m or less. When the average fiber length is 10 $\mu$m or more, anisotropic fillers are appropriately in contact with each other inside the heat conductive layer to secure a heat transfer path, making the thermally conductive properties of the heat conductive layer good.

On the other hand, when the average fiber length is 500 $\mu$m or less, the anisotropic filler has a reduced bulk, allowing the anisotropic filler to be filled highly in a binder component.

In addition, the average fiber length of the fibrous material is preferably shorter than the thickness of the heat conductive sheet. When the average fiber length is shorter than the thickness, the fibrous material is thereby prevented from protruding more than necessary from the surface of the heat conductive sheet.

Note that the average fiber length can be calculated by observing the anisotropic filler with a microscope. More specifically, the fiber lengths of 50 arbitrary anisotropic fillers are measured using, for example, an electron microscope or an optical microscope, and the average value (arithmetical mean value) can be taken as the average fiber length.

When the anisotropic filler is a flake-like material, the average particle diameter is preferably 10 $\mu$m or more and 300 $\mu$m or less, more preferably 15 $\mu$m or more and 200 $\mu$m or less, and still more preferably 20 $\mu$m or more and 100 $\mu$m or less. When the average particle diameter is 10 $\mu$m or more, anisotropic fillers are easily in contact with each other in the heat conductive layer to secure a heat transfer path, making the thermally conductive properties of the heat conductive layer good. On the other hand, when the average particle diameter is 400 $\mu$m or less, the heat conductive sheet has a reduced bulk, allowing the anisotropic filler to be filled highly in a binder component.

Note that the average particle diameter of a flake-like filler is represented by D50, which can be calculated by observing the flake-like filler with a microscope and taking the major axis as the diameter. More specifically, the D50 refers to a particle diameter corresponding to a cumulative frequency of 50%, whose measurement is taken from the major axis of 500 or more arbitrary flake-like fillers using, for example, an electron microscope or an optical microscope. Specifically, the D50 can be determined from a particle diameter distribution curve, where the horizontal axis represents the particle diameter and the vertical axis represents the cumulative frequency, using the flake-lake filler as a sample. The particle diameter distribution curve is a number-based particle diameter distribution curve to be obtained in sequential cumulation from a flake-like filler having the smallest particle size.

As the anisotropic filler, a known material having thermally conductive properties may be used. As will be described later, the anisotropic filler may have diamagnetism in the case of being oriented by magnetic field orientation. On the other hand, the anisotropic filler may not have diamagnetism in the case of being oriented by flow orientation or not oriented.

Specific examples of the anisotropic filler include a carbon-based material represented by carbon fiber or flake-like carbon powder, a metal material represented by metal fiber, a metal oxide, boron nitride, a metal nitride, a metal carbide, a metal hydroxide, and a polyparaphenylene benzoxazole fiber, among which a carbon-based material has a small specific gravity and the good dispersing ability into the binder component and is therefore preferable. In particular, a graphitized carbon material with high thermal conductivity is more preferable. When including graphite planes uniformly facing a predetermined direction, a graphitized carbon material has diamagnetism.

Boron nitride is also preferable as the anisotropic filler. Boron nitride is preferably used as, but not limited to, a flake-like material. Flake-like boron nitride may be agglomerated or may not agglomerated, but a part or the whole thereof is preferably non-agglomerated. Note that when including crystal planes uniformly facing in a predetermined direction, boron nitride and the like also have diamagnetism.

The anisotropic filler has a thermal conductivity of generally 30 W/m·K or more, preferably 60 W/m·K or more, more preferably 100 W/m·K or more, and still more preferably 200 W/m·K or more along a direction of having anisotropy (i.e., major axis direction), although not limited thereto. The thermal conductivity of the anisotropic filler is, for example, 2000 W/m·K or less, although the upper limit thereof is not limited. The thermal conductivity can be measured by laser flash analysis or the like.

The anisotropic filler may be used alone or in combination with two or more thereof. As the anisotropic filler, for example, at least two anisotropic fillers each having a different average particle diameter or average fiber length may be used. It is considered that the use of anisotropic fillers, each of which has a different size, allows the anisotropic fillers to be filled at a high density in the binder component and enhancement of heat-conducting efficiency, as a small anisotropic filler gets in between relatively larger anisotropic fillers.

In addition, the anisotropic filler preferably contains a fibrous material among the above. When sliced as described later, a heat conductive layer containing fibrous material is likely to have poor adhesion due to the loss of the fibrous material and resultant unevenness on the surface. In the present invention, however, an acrylic pressure-sensitive adhesive layer gets in a depression of the surface when the acrylic pressure-sensitive adhesive layer is provided. Thus, even the heat conductive layer having fibrous material is able to have sufficiently enhanced adhesion.

From the viewpoint of enhancing the thermally conductive properties, the heat conductive layer preferably contains a flake-like material as an anisotropic filler in addition to the fibrous material. In this case, the content ratio of the flake-like material to the fibrous material (flake-like material/fibrous material) on a mass basis is, for example, 0.01 or more and 1 or less, preferably 0.02 or more and 0.5 or less, and more preferably 0.1 or more and 0.3 or less.

The carbon fiber to be used as the anisotropic filler is preferably a graphitized carbon fiber. In addition, the flake-like carbon powder is preferably flake-like graphite powder. It is also preferable to use graphitized carbon fiber and flake-like graphite powder in combination as the anisotropic filler.

Graphitized carbon fiber features a series of crystal planes of graphite connected in the fiber axis direction and has a high thermal conductivity in the fiber axis direction. Therefore, aligning the fiber axis direction in a predetermined direction enables thermal conductivity in a specific direction to be increased. Flake-like graphite powder features a series of crystal planes of graphite connected in the in-plane direction of flake planes and has a high thermal conductivity in the in-plane direction. Therefore, aligning the flake planes in a predetermined direction enables thermal conductivity in a specific direction to be increased. The graphitized carbon fiber and the flake graphite powder preferably have a high degree of graphitization.

The following raw materials graphitized are available for the above-described graphitized carbon materials, such as graphitized carbon fiber and flake-like graphite powder. Examples thereof include fused polycyclic hydrocarbon compounds such as naphthalene, and fused heterocyclic compounds such as polyacrylonitrile (PAN) and pitch. In particular, graphitized mesophase pitch having a high degree of graphitization, polyimide, and polybenzazole are preferably used. For example, when using mesophase pitch, it is possible to produce graphitized carbon fiber having excellent thermally conductive properties in the fiber axis direction because the pitch becomes oriented in the fiber axis direction due to its anisotropy in a spinning step described later.

The type of usage of the mesophase pitch in the graphitized carbon fiber in an aspect is not limited as long as it is spinnable. The mesophase pitch may be used alone or in combination with another raw material, provided that the mesophase pitch to be used alone, that is, graphitized carbon fiber having a mesophase pitch content of 100% is most preferable in terms of increasing thermal conduction, spinnability, and quality stability.

The graphitized carbon fiber available may be fiber obtained by sequentially performing processes of spinning, infusibilizing, and carbonizing, then pulverizing or cutting the resultant to a predetermined particle size, followed by graphitization, or fiber obtained by carbonizing the fiber, then pulverizing or cutting the resultant, followed by graphitization. When the fiber is pulverized or cut before graphitization, a condensation polymerization reaction and a cyclization reaction easily proceed on the surface that becomes newly exposed due to the pulverization, thus increasing the degree of graphitization. As a result, graphitized carbon fiber having further enhanced thermally conductive properties can be obtained. Meanwhile, when spun carbon fiber is graphitized and then pulverized, the post-graphitized carbon fiber is rigid and thus easily pulverized. Accordingly, pulverization allows carbon fiber powder with a relatively narrow fiber length distribution to be produced in a short time.

As described above, the average fiber length of the graphitized carbon fiber is preferably 10 $\mu$m or more and 300 $\mu$m or less, more preferably 20 $\mu$m or more and 200 $\mu$m or less, and still more preferably 30 $\mu$m or more and 100 $\mu$m or less. In addition, the aspect ratio of the graphitized carbon fiber exceeds 2 as described above, and is preferably 5 or more. The thermal conductivity of the graphitized carbon fiber is not limited, but the thermal conductivity in the fiber axis direction is preferably 400 W/m·K or more, and more preferably 800 W/m·K or more.

When the heat conductive layer contains an anisotropic filler, the anisotropic filler may or may not be exposed on the surface of the heat conductive layer, but is preferably exposed. When the anisotropic filler is exposed, the anisotropic filler is in contact with an adherend, such as a heating element or a heat-dissipating element, and it becomes easy for a thermal resistance value to be lower. In addition, when the anisotropic filler is exposed, it is hard to enhance the adhesion to the adherend. Even in such a case, however, in the present invention, a pressure-sensitive adhesive layer is provided to facilitate the enhancement of the adhesion.

(Non-anisotropic Filler)

The heat conductive filler in the present invention may contain a non-anisotropic filler, and it is preferable to use the above-described anisotropic filler and the non-anisotropic filler in combination.

In particular, when the non-anisotropic filler is used in combination with the anisotropic filler oriented in one direction, such as the thickness direction, the non-anisotropic filler is interposed in the gap among the oriented anisotropic fillers, thereby further enhancing thermally conductive properties. The non-anisotropic filler is a filler having substantially no anisotropy in shape, and is not oriented in a predetermined direction, even in an environment where the anisotropic filler is oriented in the predetermined direction, such as under the generation of magnetic field lines or the action of shear force as described later.

The non-anisotropic filler has an aspect ratio of 2 or less, preferably 1.5 or less. When a non-anisotropic filler having such a low aspect ratio is used in combination with anisotropic fillers, the non-anisotropic filler is likely to be disposed in the gap among the anisotropic fillers, which facilitates the enhancement of the thermal conductivity. In addition, when the aspect ratio is 2 or less, it is possible to prevent the viscosity of a mixed composition described later from increasing and to achieve high filling.

Specific examples of the non-anisotropic filler include a metal, a metal oxide, a metal nitride, a metal hydroxide, a carbon material, and an oxide, a nitride, and a carbide other than a metal. Examples of the shape of the non-anisotropic filler include spherical, polyhedral, and amorphous powder.

As the non-anisotropic filling material, examples of the metal include aluminum, copper, and nickel, examples of the metal oxide include aluminum oxide represented by alumina, magnesium oxide, and zinc oxide, and examples of the metal nitride include aluminum nitride. Examples of the metal hydroxide include aluminum hydroxide. Furthermore, examples of the carbon material include spherical graphite. Examples of the oxide, nitride, and carbide other than the metal include quartz, boron nitride and silicon carbide.

Among them, aluminum oxide and aluminum are preferable because they have high thermal conductivity and are readily available in spherical shape.

The non-anisotropic filler described above may be used alone or in combination with two or more thereof.

The average particle diameter of the non-anisotropic filler is, for example, 0.1 $\mu$m or more and 200 $\mu$m or less, preferably 0.5 $\mu$m or more and 100 $\mu$m or less, and more preferably 1 $\mu$m or more and 70 $\mu$m or less.

In the case of using the non-anisotropic filler in combination with an anisotropic filler, the average particle diameter of the non-anisotropic filler is preferably 0.1 $\mu$m or more and 50 $\mu$m or less, more preferably 0.5 $\mu$m or more and 35 $\mu$m or less, and still more preferably 1 $\mu$m or more and 15 $\mu$m or less. When the average particle diameter is adjusted to 50 $\mu$m or less, the non-anisotropic filler does not cause defects such as disturbing the orientation of an anisotropic filler, even when used in combination with the anisotropic filler. When the average particle diameter is adjusted to 0.1 $\mu$m or more, the specific surface area of the non-anisotropic filler does not become unnecessarily large, and the viscosity of the mixed composition hardly increases even when blended in a large amount, facilitating high filling of the non-anisotropic filler.

As the non-anisotropic filler, for example, at least two non-anisotropic fillers each having a different average particle diameter may be used.

Note that the average particle diameter of the non-anisotropic filler can be measured by observation with an electron microscope or the like. More specifically, the particle sizes of 500 or more arbitrary non-anisotropic fillers are measured using, for example, an electron microscope or an optical microscope to determine D50 in the same manner as for the flake-like filler.

The content of the non-anisotropic filler is preferably 50 parts by mass or more and 2500 parts by mass or less, more preferably 100 parts by mass or more and 1500 parts by mass or less, and still more preferably 200 parts by mass or more and 750 parts by mass or less, based on 100 parts by mass of the polymer matrix. When the content is 50 parts by mass or more, the heat conductive sheet may have enhanced thermally conductive properties. Meanwhile, when the content is 1500 parts by mass or less, the non-anisotropic filler can be properly dispersed in the binder component to obtain an effect of enhancing the thermally conductive properties corresponding to the content. In addition, it is possible to prevent the viscosity of mixed composition from unnecessarily increasing.

The mass ratio of the content of the non-anisotropic filler to the content of the anisotropic filler is preferably 0.5 or more and 15 or less, more preferably 1 or more and 10 or less, and still more preferably 1.1 or more and 7 or less, although not limited thereto. When the mass ratio is within the above range, the non-anisotropic filler can be adequately filled among the anisotropic fillers to form an efficient heat transfer path, thereby further enhancing the thermal conductive properties of the heat conductive sheet.

In the heat conductive layer, components other than the above may further be blended in the polymer matrix within a range that does not impair the function as the heat conductive layer. Specific examples thereof include at least one selected from the group consisting of a dispersant, a flame retardant, an antioxidant, a coloring agent, an anti-settling agent, and the like. In the case where, the curable polymer composition is subjected to crosslinking, curing, or the like, as described above, a crosslinking accelerator, a curing accelerator, a curing catalyst, or the like that accelerates crosslinking or curing the composition may be blended as an additive. As the curing catalyst, a platinum catalyst may be used when the polymer matrix is organopolysiloxane.

The surface of the heat conductive layer is preferably a slice surface. When the surface of the heat conductive layer is a slice surface, the anisotropic filler or the like can be easily exposed to the surface of the heat conductive layer as described above, thereby effectively lowering the thermal resistance value. The heat conductive sheet may have a slice surface on one surface thereof or a slice surface on both surfaces, and the surface on which the acrylic pressure-sensitive adhesive layer is provided is preferably a slice surface. As will be described later, the slice surface is formed by cutting with a shear blade, a laser, or the like.

Although the slice surface is often in a highly uneven state due to the protrusion or detachment of the anisotropic filler, filling the depression with an acrylic pressure-sensitive adhesive layer can reduce an air layer during use, thereby enhancing the adhesion while enhancing the thermal resistance value.

In addition, the surface of the heat conductive sheet is preferably a polished surface. When at least one surface of the heat conductive sheet is a polished surface, the thermal resistance value can be more effectively lowered. Although the heat conductive sheet may have a polished surface on one surface thereof or a polished surface on both surfaces thereof, the surface on which the acrylic pressure-sensitive adhesive layer is provided is preferably a polished surface, particularly preferably a slice surface and a polished surface. Since the polished surface has relatively high smoothness, the adhesion to an adherend can be easily enhanced coupled with the formation of the acrylic pressure-sensitive adhesive layer.

The thickness of the heat conductive layer is, for example, about 1200 $\mu$m or less, although not limited thereto. From the viewpoint of suitable use in semiconductor applications and prevention of a large thermal resistance value, it is better to make the heat conductive layer relatively thin, and the thickness is preferably 500 $\mu$m or less, more preferably 300 $\mu$m or less, and still more preferably 200 $\mu$m or less. The thickness of the heat conductive layer is practically, for example, 10 $\mu$m or more, preferably 20 $\mu$m or more, and more preferably 70 $\mu$m or more, although not limited thereto. Note that the thickness of the heat conductive layer is an initial thickness to be measured in a state where no load is applied in the thickness direction.

(Arithmetic Average Height (Sa))

The arithmetic average height (Sa) of the surface of the heat-conducting sheet on which the acrylic pressure-sensitive adhesive layer is provided is, for example, 20 $\mu$m or less, preferably 12 $\mu$m or less, more preferably 6 $\mu$m or less, and still more preferably 5 $\mu$m or less. The heat-conducting sheet can lower the thermal resistance value more effectively by decreasing the arithmetic average height of the surface on which the acrylic pressure-sensitive adhesive layer is provided. In addition, the acrylic pressure-sensitive adhesive layer can tightly adhere to an adherend more effectively. Note that the surface of the heat conductive sheet tends to have a relatively large arithmetic average height when, for example, a slice surface is used as described above, but the arithmetic average height (Sa) can be lowered as described above by polishing after slicing.

The arithmetic average height (Sa) of the surface of the heat-conducting sheet on which the acrylic pressure-sensitive adhesive layer is provided is preferably 0.5 $\mu$m or more, more preferably 1 $\mu$m or more, and still more preferably 2 $\mu$m or more, although not limited thereto. The arithmetic average height (Sa) can be obtained relatively easily by polishing even the slice surface when being equal to or greater than the lower limit.

(E Hardness)

A heat conductive layer of the present invention has a type E hardness (hereinafter, also referred to as "E hardness") as specified in JIS K6253 of preferably 10 or more and 80 or less, more preferably 20 or more and 70 or less, and still more preferably 30 or more and 65 or less. When the E hardness is equal to or greater than the lower limit, the mechanical strength of the heat conductive sheet is easily enhanced. When the E hardness is equal to or less than the upper limit, a certain degree of flexibility is imparted to the heat conductive sheet, which also facilitates the enhancement of adhesion to an adherend.

(Thermal Resistance Value of Heat Conductive Sheet)

The heat conductive sheet of the present invention has a heat resistance value of, for example, 0.5°C·cm$^2$/W or less, preferably 0.25°C·cm$^2$/W or less, more preferably 0.2°C·cm$^2$/W or less, and still more preferably 0.16°C·cm$^2$/W or less. When the heat resistance value is equal to or less than the upper limit, the efficiency of heat transfer from the heating element to the heat-dissipating element via the heat conductive sheet is enhanced, resulting in excellent thermally conductive properties. In the present invention, the lower the thermal resistance value, the better. The heat resistance value may be 0°C·cm$^2$/W or more, and is practically, for example, 0.01°C·cm$^2$/W or more, and preferably 0.05°C·cm$^2$/W or more.

Note that the thermal resistance value is a thermal resistance value measured when a pressure of 20 psi (138 kPa) is applied in the thickness direction, and can be specifically obtained according to a measurement method described in Examples.

[Method for Producing Heat Conductive Sheet]

The heat conductive sheet of the present invention can be produced according to a method including at least the following steps 1 to 3, although the heat conductive sheet of the present invention may be produced according to a method other than the following production method:

Step 1: mixing at least a curable polymer composition and a heat conductive filler to obtain a mixed composition
Step 2: curing the mixed composition by heating to obtain a cured product
Step 3: applying a pressure-sensitive adhesive to a surface of the cured product

Additionally, in the present invention, the method preferably includes the following step 4:
Step 4: allowing the applied pressure-sensitive adhesive to permeate into the cured product

(Step 1)

In step 1, a mixed composition may be obtained by mixing at least a curable polymer composition and a heat conductive filler, but the mixed composition is preferably further mixed with a volatile substance. In addition, another component such as an additive to be blended, when necessary, may be appropriately added to the mixed composition.
In step 1, as long as the above components can be mixed to obtain a mixed composition, a mixing method and mixing order thereof are not limited, and the curable polymer composition, the heat conductive filler, the volatile substance to be added when necessary, and the other component to be optionally added, when necessary, may be appropriately mixed in any order to obtain a mixed composition.
The curable polymer composition, as described above, may comprise, for example, a base resin and a curing agent (for example, an alkenyl group-containing organopolysiloxane and a hydrogenorganopolysiloxane in an addition-reaction type silicone). In such a case, the base resin, the curing agent, the heat conductive filler, volatile substance to be optionally added when necessary, and the other component may be mixed in any order to obtain a mixed composition.
The form of the mixed composition may be either a one-liquid type or a two-liquid type in which a first agent and a second agent are used in combination. In the two-liquid type, a mixed composition is obtained by mixing the first agent and the second agent together during use.

(Volatile Substance)

The volatile substance to be used in the present invention may be any component that volatilizes in step 2 described later. The volatile substance can be volatilized by heating during curing, thereby increasing the proportion of the heat conductive filler contained in the heat conductive sheet. In addition, the mixed composition has a reduced viscosity due to the inclusion of the volatile substance, thereby making it easy to increase the amount of the heat conductive filler blended and also orient the anisotropic filler in a predetermined direction, for example, by magnetic field orientation described later.
Furthermore, since a large number of fine cells are formed in the cured product due to the volatilization of the volatile substance, the pressure-sensitive adhesive is likely to permeate into the heat conductive layer in step 4 described later.
The volatile substance is preferably a compatible substance that is compatible with or dissolves in the curable polymer composition. When the volatile substance is a compatible substance, the curable polymer composition and the volatile substance can be uniformly mixed, which makes it easier to reduce the viscosity and increase the amount of the heat conductive filler blended. Furthermore, cells formed by volatilization of the volatile substance can be made fine and uniform.
The volatile substance is preferably a substance that is liquid at normal temperature (25°C) and 1 atm.
Examples of the volatile substance include an alkoxysilane compound, a hydrocarbon-based solvent, and an alkoxysiloxane compound. These compounds can increase solubility or compatibility with the curable polymer composition, thus making it easier to reduce the viscosity of the mixed composition and increase the amount of the heat conductive filler blended. Further, cells formed by volatilization of the volatile substance are easily made fine and uniform.
The volatile substance may be used alone, or two or more kinds thereof may be used in combination.
As the volatile substance, an alkoxysilane compound is preferably used. The use of an alkoxysilane compound gives the surface of the heat conductive sheet obtained by curing no roughness or the like observed, resulting in a good appearance.
The alkoxysilane compound to be used as the volatile substance is a compound having a structure in which one to three of the four bonds of a silicon atom (Si) are bonded to alkoxy group(s), and the remaining bond(s) is(are) bonded to organic substituent(s). The alkoxysilane compound has an alkoxy group and an organic substituent, which can enhance compatibility with a curable polymer composition, particularly a curable polymer composition composed of organopolysiloxane.

Examples of the alkoxy group contained in the alkoxysilane compound include a methoxy group, an ethoxy group, a protoxy group, a butoxyl group, a pentoxy group, and a hexatoxy group. The alkoxysilane compound may be contained as a dimer in the curable polymer composition.

Among the alkoxysilane compounds, an alkoxysilane compound having at least one of a methoxy group and an ethoxy group is preferable from the viewpoint of availability. The number of alkoxy groups contained in the alkoxysilane compound is preferably 2 or 3, and more preferably 3, from the viewpoint of compatibility and solubility with the curable polymer composition. Specifically, the alkoxysilane compound is preferably at least one selected from the group consisting of a trimethoxysilane compound, a triethoxysilane compound, a dimethoxysilane compound, and a diethoxysilane compound.

Examples of the functional group contained in the organic substituent of the alkoxysilane compound include an acryloyl group, an alkyl group, a carboxyl group, a vinyl group, a methacryl group, an aromatic group, an amino group, an isocyanate group, an isocyanurate group, an epoxy group, a hydroxyl group, and a mercapto group. When a platinum catalyst is used as a curing catalyst for the curable polymer composition composed of organopolysiloxane, it is preferable to select and use an alkoxysilane compound that hardly affects the curing reaction of the organopolysiloxane. Specifically, when an addition-reaction type organopolysiloxane utilizing a platinum catalyst is used, the organic substituent of the alkoxysilane compound preferably contains no amino group, isocyanate group, isocyanurate group, hydroxyl group, or mercapto group.

The alkoxysilane compound preferably contains an alkylalkoxysilane compound having an alkyl group bonded to a silicon atom, that is, an alkoxysilane compound having an alkyl group as an organic substituent, from the viewpoint of compatibility with the curable polymer composition composed of organopolysiloxane. Therefore, a dialkyldialkoxysilane compound and an alkyltrialkoxysilane compound are preferable, and in particular, an alkyltrialkoxysilane compound is preferable.

The number of carbon atoms of the alkyl group bonded to the silicon atom may be, for example, 1 to 16. In a trialkoxysilane compound such as a trimethoxysilane compound or a triethoxysilane compound, the number of carbon atoms of the alkyl group is preferably 6 or more, more preferably 8 or more, and the number of carbon atoms is preferably 12 or less, more preferably 10 or less.

On the other hand, in a dialkoxysilane compound such as a dimethoxysilane compound or a triethoxysilane compound, the number of carbon atoms of the alkyl group may be 1 or more, and the number of carbon atoms is preferably 10 or less, more preferably 6 or less, and still more preferably 4 or less.

Examples of alkyl group-containing alkoxysilane compounds include methyltrimethoxysilane, dimethyldimethoxysilane, diethyldimethoxysilane, trimethylmethoxysilane, methyltriethoxysilane, dimethyldiethoxysilane, ethyltrimethoxysilane, n-propyltrimethoxysilane, di-n-propyldimethoxysilane, di-n-propyldiethoxysilane, isobutyltrimethoxysilane, isobutyltriethoxysilane, isobutyltrimethoxysilane, isobutyltriethoxysilane, n-hexyltrimethoxysilane, n-hexyltriethoxysilane, methylcyclohexyldimethoxysilane, methylcyclohexyldiethoxysilane, n-octyltrimethoxysilane, n-octyltriethoxysilane, n-decyltrimethoxysilane, and n-decyltriethoxysilane.

Among the alkyl group-containing alkoxysilane compounds, n-decyltrimethoxysilane and n-octyltriethoxysilane are more preferable from the viewpoint of compatibility with organopolysiloxane that makes up the curable polymer composition.

The alkoxysiloxane compound to be used as the volatile substance has a structure having two or more siloxane bonds in which an alkoxy group is bonded to at least one silicon atom. The alkoxysiloxane compound has a structure in which an organic substituent is bonded to at least one of the silicon atoms forming the siloxane bonds. The alkoxysiloxane compound has an alkoxy group and an organic substituent, which can enhance compatibility with the organopolysiloxane that makes up the curable polymer composition.

Examples of the alkoxy group and the organic substituent contained in the alkoxysiloxane compound include groups illustrated in the description of the alkoxysilane compound above. From the viewpoint of compatibility with the organopolysiloxane that makes up the curable polymer composition, the alkoxysiloxane compound preferably has at least at alkyl group.

Examples of the alkoxysiloxane compound include a methylmethoxysiloxane oligomer, a methylphenylmethoxysiloxane oligomer, a methylepoxymethoxysiloxane oligomer, a methylmercaptomethoxysiloxane oligomer, and a methylacryloylmethoxysiloxane oligomer.

One or more alkoxysiloxane compounds can be used.

Examples of the hydrocarbon-based solvent to be used as the volatile substance include an aromatic hydrocarbon-based solvent. In particular, an aromatic hydrocarbon-based solvent is preferable from the viewpoint of compatibility with the curable polymer composition. Examples of the aromatic hydrocarbon-based solvent include an aromatic hydrocarbon-based solvent having about 6 to 10 carbon atoms, such as toluene, xylene, mesitylene, ethylbenzene, propylbenzene, butylbenzene, and t-butylbenzene, preferably toluene and xylene.

In the mixed composition, the content of the volatile substance is preferably 6 part by mass or more and 60 parts by mass or less based on 100 parts by mass of the curable polymer composition. When the content is 6 part by mass or more, the effect of containing the volatile substance is easily exhibited, and for example, an appropriate amount of fine cells can be formed in the polymer matrix. When the amount is 60 parts by mass or less, an effect according to the amount of the volatile substance used can be obtained. From these viewpoints, the content of the volatile substance is more preferably 8 parts by mass or more and 50 parts by mass or less, and still more preferably 10 parts by mass or more and 35 parts by mass or less.

Note that a part or all of the volatile substance is preferably volatilized by heating in step 2. Therefore, the volatile substance may not be contained in the heat conductive sheet. However, the volatile substance may be contained in the heat conductive sheet in a smaller amount than the content in the mixed composition.

The details of the components other than the volatile substance in the mixed composition (that is, the curable polymer composition, the heat conductive filler, another additive, etc.) are as described above. The content of the heat conductive filler in the mixed composition is also as described above, provided that the content of each component in the above description is shown as an amount based on 100 parts by mass of the polymer matrix, but in the mixed composition, the content is an amount based on 100 parts by mass of the curable polymer composition.

(Step 2)

Step 2 is the step that cures the mixed composition by heating. The temperature for heating the mixed composition is not limited as long as the curable polymer composition is curable by heating, which may be higher than room temperature (25°C), preferably 50°C or more, and more preferably 70°C or more. The heating temperature may be a temperature at which the heat conductive layer and the mixed composition do not thermally deteriorate, for example, 200°C or less, preferably 180°C or less, and more preferably 160°C or less, although not limited thereto. The heating may be performed in one stage or in two or more stages. When the heating is performed in two or more stages, the heating temperature may be within the above range at least in any stage, preferably within the above range at all stages, and it is preferable that the heating is performed at a temperature lower than the boiling point of the volatile compound at least in the first stage. In addition, the total heating time is, for example, about 10 minutes to 24 hours. When two or more stages are performed, for example, the mixed composition may be semi-cured in the first stage (primary curing), and the mixed composition may be fully cured by heating in the second and subsequent stages (secondary curing). In addition, the curing may be complete curing by primary curing, and the heating after the second stage may not be accompanied by curing.

As described later, when the formed product obtained from the mixed composition is sliced into a sheet-like formed product, it is also preferable to perform heating in the first stage and primary curing before slicing, and then further heating after slicing to perform the second and subsequent stages of heating (secondary curing). The heating after slicing facilitates the volatilization of the volatile substance in the second and subsequent stages of heating.

In the case of curing in two or more stages, heating in the first stage (primary curing) may be performed at, for example, 50°C or more and 120°C or less, preferably 60°C or more and 100°C or less, and more preferably 70°C or more and 90°C or less. Heating in the second and subsequent stages (secondary curing) may be performed at higher than primary curing, for example, 100°C or more and 200°C or less, preferably 120°C or more and 180°C or less, and more preferably 140°C or more and 160°C or less. Note that the heating time in the first stage may be, for example, about 5 minutes or more and 20 hours or less, preferably about 30 minutes or more and 12 hours or less. The heating time in the second and subsequent stages is, for example, about 10 minutes or more and 15 hours or less, preferably about 1 hour or more and 10 hours or less.

When the formed product obtained from the mixed composition is subjected to heating in the first stage at a relatively low temperature as described above, the formed product can be cured so that the volatile compound is less likely to foam to generate large cells and the volatile compound remains in the formed product.

In addition, when the formed product is sliced and then subjected to heating in the second stage at a relatively high temperature, the formed product is cured. Therefore, the space where the volatile compound has existed becomes a fine cell without foaming and generating a large cell even at a high temperature. The cell size is, for example, 1 $\mu$m or less, preferably 0.2 $\mu$m or less. The lower limit of the cell size is, for example, 0.001 $\mu$m or more, although not limited thereto.

In step 2, the mixed composition may be formed into a predetermined shape, such as a block shape or a sheet shape, and cured by heating. In addition, in step 2, when the mixed composition contains an anisotropic filler as a heat conductive filler, the anisotropic filler may be oriented in one direction and then cured by heating. The anisotropic filler can be oriented according to a magnetic field orientation technique or a flow orientation technique, but the anisotropic filler is preferably oriented according to a magnetic field orientation technique.

In the magnetic field orientation technique, the mixed composition may be injected into a mold or the like and then placed in a magnetic field to orient the anisotropic filler along the magnetic field. Then, the curable polymer composition may be cured to obtain an oriented formed product. The curing of the mixed composition may be performed under the heating conditions as described above.

The oriented formed product is preferably in the shape of a block, but may be in the shape of a sheet. The oriented formed product in the shape of a sheet may be coated with the pressure-sensitive adhesive in step 3 without being sliced. On the other hand, the oriented formed product in the shape of a block enhances orientation of the anisotropic filler.

In the magnetic field orientation technique, a release film may be placed at a portion in contact with the mixed composition inside the mold. As the release film, for example, a resin film having good release properties or a resin film with one side subjected to a release treatment with a release agent or the like is used. The use of the release film facilitates the release of the oriented formed product from the mold.

The viscosity of the mixed composition used in the magnetic field orientation technique is preferably 10 Pa·s or more and 300 Pa·s or less for magnetic field orientation. When the viscosity is 10 Pa·s or more, the heat conductive filler is less likely to settle. In addition, since the viscosity of 300 Pa·s or less makes the fluidity good, the anisotropic filler is properly oriented by the magnetic field without defects such as too much time required for orientation. Note that the viscosity is measured at 25°C using a rotational viscosimeter (Brookfield viscosimeter DV-E, spindle SC4-14) at a rotation speed of 10 rpm.

However, the viscosity of the mixed composition may be less than 10 Pa·s in the case where a heat conductive filler that is difficult to settle is used or an additive such as an anti-settling agent is combined.

In the magnetic field orientation technique, a magnetic field line source for applying magnetic field lines includes a superconducting magnet, a permanent magnet, and an electromagnet, and a superconducting magnet is preferable because a magnetic field with a high magnetic flux density can be generated. The magnetic flux density of the magnetic field generated from the magnetic field line sources is preferably 1 to 30 tesla. When the magnetic flux density is 1 tesla or more, the above-described anisotropic filler made of a carbon material or the like can be easily oriented. When the magnetic flux density is 30 tesla or less, the anisotropic filler can be practically produced.

In the flow orientation technique, a shear force is applied to the mixed composition to produce a primary sheet in which the anisotropic filler is oriented along the plane direction. More specifically, in the flow orientation technique, the mixed composition prepared in step 1 is first stretched flat while applying a shear force to form a sheet-like shape (primary sheet). The anisotropic filler can be oriented in the shear direction by applying a shear force. As a method of forming the sheet, for example, a coating applicator such as a bar coater or a doctor blade, or extrusion molding or ejection from a nozzle may be used to apply the mixed composition to the base material film, which is then, when necessary, dried, semi-cured, or fully cured. The thickness of the primary sheet is preferably about 50 $\mu$m or more and 5000 $\mu$m or less. In the primary sheet, the anisotropic filler is oriented in one direction along the plane direction of the sheet.

The mixed composition used in the flow orientation technique has a relatively high viscosity so that a shear force is applied when stretched in a sheet shape. Specifically, the viscosity of the mixed composition is preferably 3 Pa·s or more and 500 Pa·s or less.

The primary sheet may be used as a heat conductive sheet as it is without being formed into a block as described later. In addition, a laminated block (block-shaped oriented formed product) may be formed by laminating a plurality of primary sheets so that the orientation directions are the same, and then adhering the primary sheets to each other by hot pressing or the like while curing the primary sheets by heating when necessary.

In the case of forming a laminated block, after irradiating at least one of the surfaces of the primary sheets to be overlapped with each other with vacuum ultraviolet light, the primary sheets may be overlapped with each other. When the primary sheets are overlapped with each other through the surface irradiated with vacuum ultraviolet light, the primary sheets can be strongly adhered to each other. In addition, in the case of irradiating with vacuum ultraviolet light, the mixed composition may be fully cured when the primary sheet is prepared, and it is not necessary to cure the mixed composition by heating or the like when the primary sheets are overlapped to form a laminated block.

In the flow orientation technique, the curing of the mixed composition may also be performed under the heating conditions as described above.

As described above, when the block-shaped oriented formed product is formed, the resulting oriented formed product should be cut by slicing or the like perpendicularly to the direction in which the anisotropic filler is oriented to form a sheet-like formed product. The slicing may be performed with a shear blade or a laser, for example. In the sheet-like formed product, due to the cutting through slicing or the like, a part of a fibrous filler may be exposed from the matrix on each surface which is the cut surface. The exposed fibrous filler is mostly oriented in the thickness direction without falling down.

In step 2, however, the fibrous filler contained in the oriented formed product may be cut in accordance with the cutting of the oriented formed product by slicing or the like within a range that does not impair the effects of the present invention.

The sheet-like formed product obtained by cutting may be coated with a pressure-sensitive adhesive as it is in step 3 described later or may be further subjected to another treatment. For example, each surface, which is a slice surface, may be polished. In addition, secondary curing may be performed as described above. The secondary curing may be performed after or before polishing.

When the sheet-like formed product is polished, the surface state of the sheet-like formed product is further enhanced, thereby further reducing the thermal resistance value easily. When the sheet-like formed product is polished, the surface of the sheet can be smoothed while a certain amount of the anisotropic filler such as the fibrous filler is exposed on the surface, or the fibrous filler can be brought into a fallen state. Therefore, the surface of the heat conductive sheet is easily adhered to another member, and the surface of the sheet is easily covered with the fibrous filler in a certain area or more, whereby the thermal resistance value is easily reduced.

In the polishing, at least one surface of the obtained sheet-like formed product may be polished, and it is preferable to polish both surfaces of the sheet-like formed product. The polishing of the surface may be performed using, for example, sandpaper, a polishing film, a polishing cloth, and a polishing belt.

The sandpaper preferably has, as its characteristic, an average grain size (D50) of the abrasive grains contained therein of 0.1 μm or more and 100 μm or less, and more preferably of 1 μm or more and 60 μm or less. The grain size of abrasive grains of sandpaper is preferably #120 to 20000, preferably #300 to 15000, and more preferably #320 to 4000.

Among possible polishing methods used are, for example, allowing sandpaper to abut on the surface of the sheet-like formed product continuously in the same linear direction for polishing, reciprocating sandpaper on the surface of the sheet-like formed product within a certain distance for polishing, rotating sandpaper in the same direction on the surface of the sheet-like formed product for polishing, or allowing sandpaper to abut on the surface of the sheet-like formed product in various directions for polishing.

Regarding the extent of polishing, the polishing may be conducted, for example, while observing the surface state . However, in the case of reciprocation polishing, for example, the number of reciprocations is preferably 1 or more and 300 or less, more preferably 2 or more and 200 or less, and still more preferably 3 or more and 50 or less.

The surface of the sheet-like formed product may be polished in two separate polishing steps. For example, after the first polishing using sandpaper having a large average grain diameter of abrasive grains, the second polishing may be conducted using sandpaper having a smaller average grain diameter of abrasive grains than that in the first polishing.

(Step 3)

In step 3, a pressure-sensitive adhesive is applied to the surface of the cured product such as the sheet-like formed product obtained in step 2, as described above. In the present invention, as the pressure-sensitive adhesive to be applied, the acrylic-based pressure-sensitive adhesive having a reactive double bond as described above may be used.

In addition, in the present production method, it is preferable to make the pressure-sensitive adhesive permeate into the heat conductive layer in step 4, and the pressure-sensitive adhesive preferably permeates into the inside of the heat conductive layer by just applying the pressure-sensitive adhesive. In other words, steps 3 and 4 preferably proceed at the same time.

The pressure-sensitive adhesive may also be diluted with a diluent and applied to the surface of the sheet-like formed product as a pressure-sensitive adhesive diluted solution. Dilution of the pressure-sensitive adhesive with a diluent makes it easier to allow the pressure-sensitive adhesive to permeate into the heat conductive layer. The diluent is not limited as long as it is a component that is liquid at 25°C and 1 atm, soluble or compatible with the pressure-sensitive adhesive, and volatilizes due to drying, which will be described later, but an organic solvent can be preferably used.

Examples of the organic solvent to be used include, but not limited to, a ketone compound such as acetone, methyl ethyl ketone, and cyclohexanone; an aromatic hydrocarbon compound such as toluene, xylene, and tetramethylbenzene; a glycol ether compound such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether, tripropylene glycol monomethyl ether, and polyethylene glycol monoethyl ether; an ester compound such as ethyl acetate, butyl acetate, butyl lactate, cellosolve acetate, butyl cellosolve acetate, carbitol acetate, butyl carbitol acetate, propylene glycol monomethyl ether acetate, dipropylene glycol monomethyl ether acetate, propylene glycol monoethyl ether acetate, and propylene glycol monopropyl ether acetate; and an aliphatic hydrocarbon compound such as hexane, octane, and decane.

From the viewpoint of performing spray coating to be described later and appropriately allowing the pressure-sensitive adhesive to permeate into the heat conductive layer, the diluent preferably contains, as the organic solvent, any one of cellosolve acetate, butyl cellosolve acetate, carbitol acetate, butyl carbitol acetate, propylene glycol monomethyl ether acetate, dipropylene glycol monomethyl ether acetate, propylene glycol monoethyl ether acetate, propylene glycol monopropyl ether acetate, and polyethylene glycol monoethyl ether, the volatilization rate of which is not too high.

In addition to the above organic solvents, the diluent preferably further contains an organic solvent having a lower boiling point than these components, and specific examples thereof include methyl ethyl ketone, methyl isobutyl ketone, hexane, ethyl acetate, butyl acetate, and toluene.

The dilution concentration with the diluent is not limited, but may be adjusted so that the solid content concentration of the pressure-sensitive adhesive is, for example, 5% by mass or more and 50% by mass or less, preferably 8% by mass or more and 35% by mass or less, and more preferably 10% by mass or more and 25% by mass or less. When the solid content concentration is 5% by mass or more, it is possible to prevent heating more than necessary during drying and appropriately permeate a predetermined amount of the pressure-sensitive adhesive into the heat conductive layer together with the organic solvent. When the solid content concentration is 50% by mass or less, it is possible to appropriately permeate the pressure-sensitive adhesive into the heat conductive layer because the basis weight is not increased more than necessary while the viscosity can be adjusted so as to be easily impregnated. The amount of the pressure-sensitive adhesive permeating into the heat conductive layer can be adjusted by the viscosity, the solid content concentration, the type of the solvent, and the like. For example, in the case where it is desired to increase the amount of the pressure-sensitive adhesive permeating, the viscosity may be adjusted to be low while the solid content concentration may be adjusted to be high. In the case where it is desired to decrease the amount of the pressure-sensitive adhesive material permeating, the viscosity may be adjusted to be high while the solid content concentration may be adjusted to be low.

The method of applying the pressure-sensitive adhesive is not particularly limited, and a known application method may be adopted, but spray application is preferable. By spray coating, the basis weight does not increase more than necessary, and the pressure-sensitive adhesive can easily permeate into the heat conductive layer. In addition, by spray coating and suppressing the application amount, a portion with the pressure-sensitive adhesive layer and a portion without the pressure-sensitive adhesive layer can be provided on the surface of the heat conductive layer. When spray coating is performed, it is preferable to spray a pressure-sensitive adhesive containing a quick-drying organic solvent such as ethyl acetate and a slow-drying organic solvent such as polyethylene glycol monoethyl ether or propylene glycol monomethyl ether acetate. More specifically, in the case where the slow-drying organic solvent is contained, the organic solvent is prevented from being excessively volatilized when the pressure-sensitive adhesive discharged from the spray is applied to the surface of the heat conductive layer, whereby the pressure-sensitive adhesive can easily permeate into the heat conductive layer. On the other hand, in the case where the quick-drying solvent is contained, it is preferable to adjust the viscosity suitable for spraying.

The applied pressure-sensitive adhesive may be subsequently dried to volatilize the diluent. The drying temperature may be a temperature at which the reaction of the reactive double bond of the pressure-sensitive adhesive does not substantially proceed, for example, at 80°C or less, preferably 70°C or less, and more preferably 60°C or less. The lower limit of the drying temperature is not limited, but may be a normal temperature, for example, 20°C or more. From the viewpoint of shortening the drying time, the temperature is preferably 30°C or more, more preferably 40°C or more, and still more preferably 45°C or more.

The drying time may be such an extent that substantially all of the diluent contained in the applied pressure-sensitive adhesive is volatilized, and is, for example, 1 minute or more, preferably 2 minutes or more, and still more preferably 3 minutes or more. The drying time may be shorter from the viewpoint of workability, and is, for example, 24 hours or less, preferably 3 hours or less, and more preferably 1 hour or less, although not limited thereto.

[Use of Heat Conductive Sheet]

The heat conductive sheet, which is interposed between a heating element and a heat-dissipating element, transfers heat generated by the heating element to the heat-dissipating element through thermal conduction to dissipate the heat from the heat-dissipating element. The heat conductive sheet is used in electronics applications, semiconductor applications, and the like, preferably semi-conductor applications, where the heat conductive sheet may be used in any application, referred to as TIM1, and is preferably used in an application where it is applied directly to a semiconductor chip such as a silicon die, for example, between a semiconductor chip and a heat spreader.

Of course, it may also be used in applications that are not directly applied to a semiconductor chip, referred to as TIM2, in which case the heat conductive sheet may be used, for example, between a heat spreader and a cooling unit such as a heatsink or a heat pipe.

In addition, the heat conductive sheet may be used between an electronic component selected from various types serving as heating elements and a heat-dissipating element such as a heat spreader, a heatsink, a heat pipe, a heat pump, and a metal housing of an electronic device.

The heat conductive sheet may be used by being placed between two members (adherends) such as a heat-dissipating element and a heating element and may be used in a state of being adhered to each member (adherend) and being compressed.

The heat conductive sheet is preferably used in an application where it is heated to a high temperature of, for example, 200°C or more and 300°C or less, preferably 220°C or more and 270°C or less, with the sheet adhered to an adherend via the acrylic pressure-sensitive adhesive layer. Even when the heat conductive sheet of the present invention is heated to high temperatures in a state of being tightly adhered to the adherend, the adhesive force to the adherend is maintained or, in some cases, enhanced, thus preventing the sheet from peeling from the adherend even when heated to high temperatures as described above in a state of being tightly adhered to the adherend. It is to be noted that when the heating is performed, heating is preferably performed in non-pressurized state.

In semiconductor applications, the heat conductive sheet is preferably subjected to the reflow process in a state of being tightly adhered to an adherend via an acrylic pressure-sensitive adhesive layer, wherein it may be heated in the above-described temperature range in the reflow process. Note that the heat conductive sheet may be heated in the reflow process in a state of being tightly adhered to, for example, any one or both of a semiconductor chip and a heat spreader as an adherend via an acrylic pressure-sensitive adhesive layer. In this manner, the heat conductive sheet of the present invention can be used to bond the semiconductor chip and the heat spreader in the reflow process. Before heating to 200°C or more as described above, it is preferable to perform the tight adhesion step of tightly adhering the heat conductive sheet to an adherend via the acrylic pressure-sensitive adhesive layer. The tight adhesion step is performed, for example, by heating and pressurizing the heat conductive sheet at a temperature of 50°C or more and 180°C or less in a state where the heat conductive sheet is sandwiched between the adherends. The heating temperature is preferably 120°C or more and 160°C or less.

As described above, the present invention can also provide an adhesion method of sequentially performing a tight adhesion step of disposing the heat conductive sheet between a semiconductor chip and a heat spreader to tightly adhere the sheet thereto, and an adhesion step of bonding the semiconductor chip and the heat spreader, which are heated to 200°C or more after the tight adhesion step.

In the tight adhesion step, preferably, the heat conductive sheet is sandwiched between the semiconductor chip and the heat spreader and then pressurized preferably at 50°C or more and 200°C or less, more preferably 50°C or more and 180°C or less, and still more preferably 120°C or more and 160°C or less to be tightly adhered.

The heating temperature in the adhesion step is preferably 220°C or more, preferably 300°C or less, and more preferably 270°C or less. The adhesion step is preferably performed in a non-pressurized state.

Examples

Hereinafter, the present invention is described in more detail with reference to Examples, but these examples do not limit the present invention in any way.

Measurement methods and evaluation methods in the present Examples are as follows.

[A/B Ratio]

One drop of the pressure-sensitive adhesive coating liquid prepared in the same manner as the pressure-sensitive adhesive used in each of Examples and Comparative Examples was applied to a gold-plated stainless steel plate, and the plate was sufficiently dried after the application to volatilize the solvent, thereby forming an acrylic pressure-sensitive adhesive layer on the plate. Note that the drying was performed by leaving the pressure-sensitive adhesive coated plate in an environment of 80°C for 15 minutes.

The acrylic pressure-sensitive adhesive layer formed on the plate was analyzed by Raman analysis to determine the A/B value with the following machine and measurement conditions. In each of Examples and Comparative examples, the intensity at a wavenumber of 1636.1 cm$^{-1}$ was designated as "A", and the intensity at a wavenumber of 1724.4 cm$^{-1}$ was designated as "B".

(Machine Used)

"inVia Qontor" manufactured by Renishaw plc.

(Measurement Conditions)

Laser power: 50
Number of integration: 1
Laser wavelength: 785 nm
Grating: 1200 l/mm
Magnification: 50 x
Focus: focusing on the sample surface with an acrylic pressure-sensitive adhesive layer formed

[Confirmation of Permeation of Acrylic Pressure-Sensitive Adhesive Layer]

A fluorescent agent Nikkafluor-OB (manufactured by Nippon Chemical Works Co., Ltd.) was further added to a diluted solution of the pressure-sensitive adhesive used in each of Examples and Comparative Examples in an amount of 0.5 parts by mass based on 100 parts by mass of the pressure-sensitive adhesive. Using the diluent solution prepared in this manner, a heat conductive sheet was produced in the same manner as in each of Examples and Comparative Examples. A cross-section (observation surface) formed by slicing the heat conductive sheet in the thickness direction was observed with a fluorescent microscope. Since the portion where the fluorescence due to the fluorescent agent was observed was the portion where the pressure-sensitive adhesive was allowed to permeate, it was confirmed whether or not the pressure-sensitive adhesive permeated into the heat conductive layer. In addition, each condition of the fluorescent microscope is as follows.

Fluorescence microscope device: "Polarizing Microscope BX51" manufactured by Olympus Corporation
Light source: Mercury lamp "U-RFL-T" manufactured by Olympus Corporation
Measurement conditions: An observation surface irradiated with light of 365 nm was adjusted to focus through an optical filter that transmits visible light and absorbs ultraviolet light of 400 nm or less with a field of view of 10 times the objective lens. Then, the distribution of the luminescence (blue luminescence) of the fluorescent agent was observed under the condition of an exposure time of 800 ms using software "Stream Basic". The exposure time is not limited to the 800 ms, and the distribution of the luminescence of the fluorescent agent may be recognized under any condition. For example, the exposure time can be adjusted according to the width of the field of view and the intensity of the light source.

[Initial Sheet Thickness]

The thickness (initial thickness) of the heat conductive sheet before compression was measured with a thickness gauge.

[E Hardness]

The type E hardness of the heat conductive sheet was measured based on JIS K 6253, which is a Japanese Industrial Standard. Specifically, the oriented formed product produced in each example was measured using a type E durometer.

[Arithmetic Average Height (Sa)]

The arithmetic average height (Sa) of the surface of the heat conductive sheet was measured by surface texture analysis using a laser microscope (VK-X150, manufactured by KEYENCE CORPORATION) in accordance with ISO 25178. Specifically, the surface profile of a two dimensional region with a surface area of 1000 $\mu$m $\times$ 1000 $\mu$m was measured according to the laser method at a lens magnification of 10 times. The average value of three measurements for the same sample was adopted as the arithmetic average height (Sa) of the summit point. For the heat-conducting sheet provided with the acrylic pressure-sensitive adhesive layer, the arithmetic average height (Sa) of the surface of the heat conductive sheet provided with the acrylic pressure-sensitive adhesive layer was measured.

[Thermal Resistance Value]

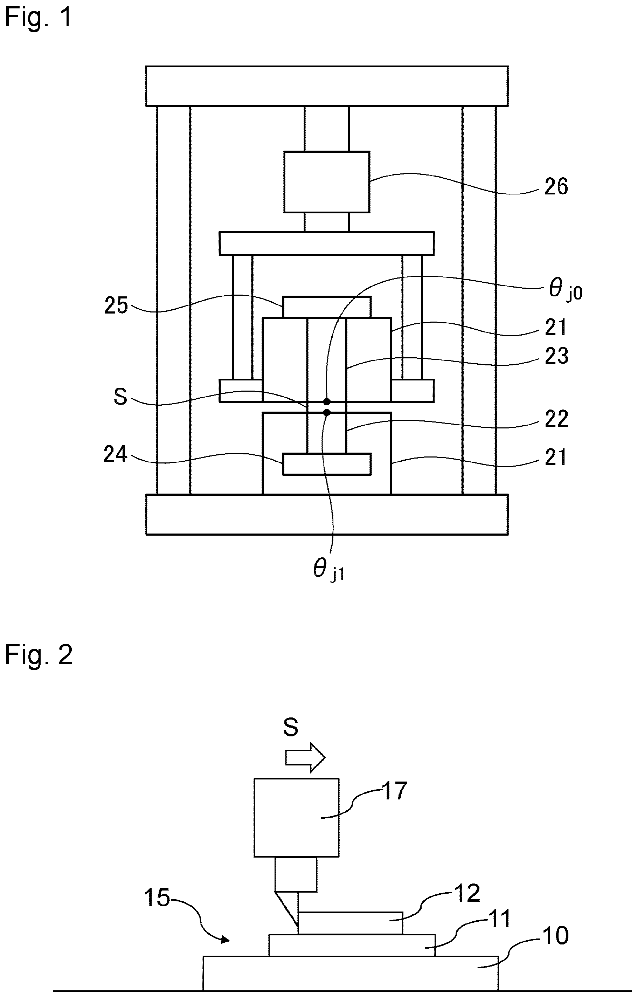

The thermal resistance value was measured according to the following method using a thermal resistance measuring machine as illustrated in Fig. 1.
Specifically, regarding each sample, a test piece S of 30 mm $\times$ 30 mm in size was prepared for this test. Then, each test piece S was attached on a copper block 22 including a measuring surface of 25.4 mm $\times$ 25.4 mm and side surfaces covered with a heat insulating material 21, sandwiched with an upper copper block 23, and loaded at a pressure of 10 psi with a load cell 26. Here, a lower copper block 22 was in contact with a heater 24. The upper copper block 23 was covered with the heat insulating material 21 and connected to a fan-equipped heat sink 25. Then, the heater 24 was heated to 80°C. After 10 minutes when the temperature was approximately in a steady state, the temperature ($\theta_{j0}$) of the upper copper block 23, the temperature ($\theta_{j1}$) of the lower copper block 22, and heat generation (Q) of the heater were measured to determine a thermal resistance value of each sample form the following equation (1). Note that, at the same time as the measurement of the thermal resistance value, the thickness of the heat conductive sheet during the measurement of the thermal resistance value was also measured.

$$\text{Thermal resistance} = (\theta_{j1} - \theta_{j0})/Q \quad \text{Equation (1)}$$

In equation (1), $\theta_{j1}$ represents the temperature of the lower copper block 22, $\theta_{j0}$ represents the temperature of the upper copper block 23, and Q represents the heat generation.
The same measurement was performed by changing the pressure applied with the load cell 26 to 20 psi, 30 psi, and 40 psi, respectively, the results of which are shown in Table 2. In addition, the thermal resistance value at a pressure of 20 psi was calculated by using the proportion of the thermal resistance value when the thermal resistance value of the blank thermal conductive sheet was taken as a reference (100%) as a rate of change in thermal resistance. Note that a heat conductive sheet having the same structure was used as a blank except that no acrylic pressure-sensitive adhesive layer was provided.

[Die Shear Strength]

As shown in Fig. 2, a heat conductive sheet 11 of 3 mm × 3 mm obtained in each of Examples and Comparative Examples was placed on a nickel-plated copper plate 10 having an outer shape of 50 mm × 50 mm and a thickness of 2 mm, and a silicon die 12 having a 3 mm × 3 mm and a thickness of 600 µm was further placed on the heat conductive sheet 11. The resulting laminated body was pressurized in the thickness direction at a pressure of 1 MPa for 60 seconds in a normal temperature environment to adhere the heat conductive sheet 11 to the nickel-plated copper plate 10 and the silicon die 12, thereby obtaining a measurement sample 15. The measurement sample 15 was placed on a hot plate whose temperature was adjusted to 250°C with the nickel-plated copper plate side 11 facing downward and heated for 3 minutes. Note that the heating at 250°C for 3 minutes is assumed to be reflow processing.

Thereafter, in an environment of 25°C, the height of a tool 17 was adjusted using a die shear tester ("Dage-S4000", manufactured by Nordson Corporation) so that the tip of the tool 17 was at a height of 300 µm from the surface of the heat conductive sheet 10. Subsequently, the tool 17 was applied to the silicon die 12 along the shear direction S at a speed of 150 µm/s, and the load required for the bonded portion to fracture was defined as a die shear strength.

In addition, the die shear strength of the measurement sample without heating at 250°C for 3 minutes was similarly measured in the environment of 25°C, and the die-shear strength measured in the environment of 25°C without heating at 250°C for 3 minutes was used as a blank.

The measurement of the die shear strength using the die shear tester was similarly performed on a measurement sample prepared in the same manner in an environment of 80°C and an environment of 150°C. The die shear strengths measured in the environments of 25°C, 80°C, and 150°C are shown in Table 2.

The die shear strength after heating at 250°C for 3 minutes (i.e., reflow processing), which was measured in the environments of 25°C, 80°C, and 150°C, was expressed as a percentage (%) with respect to the blank, which is shown in Table 2 as a rate of change in die shear strength. Note that a rate of change in die shear strength of 75% or more indicates a good result.

The following components were used as raw materials of the heat conductive sheet.

(Polymer Composition)

Curable silicone: addition-reaction type organopolysiloxane containing an alkenyl group-containing organopolysiloxane as a base resin and a hydrogenorganopolysiloxane as a curing agent (including a catalytic amount of a platinum catalyst)

(Volatile Substance)

n-Decyltrimethoxysilane

(Heat Conductive Filler)

Aluminum oxide 1: spherical shape, average particle diameter (D50) = 3 µm, aspect ratio of 1.0
Aluminum oxide 2: polyhedral shape, average particle diameter (D50) = 0.5 µm, aspect ratio of 1.0
Aluminum: spherical shape, average particle diameter (D50) = 3 µm, aspect ratio of 1.0 to 1.5
Graphitized carbon fiber: average fiber length (arithmetic mean) of 85 µm, diameter of 10 µm, aspect ratio of 8.5, thermal conductivity of 900 W/m·K
Flake-like boron nitride: average particle diameter (D50) = 50 µm, aspect ratio of ·20 to 50, thermal conductivity of 200 W/m·K
Flake graphite powder: average particle diameter (D50) = 15 µm, aspect ratio of 10, thermal conductivity of 550 W/m·K

(Pressure-Sensitive Adhesive)

Pressure-sensitive adhesive 1: A pressure-sensitive adhesive in which the pressure-sensitive adhesive base resin is an acrylic-based polymer containing a 2-ethylhexyl acrylate-derived structural unit as the main component and having a hydroxy group, a carboxyl group, and a vinyl group in the side chain. A/B = 0.588

Pressure-sensitive adhesive 2: A pressure-sensitive adhesive in which the pressure-sensitive adhesive base resin is an acrylic-based polymer containing a 2-ethylhexyl acrylate-derived structural unit as the main component and having a hydroxy group, a carboxyl group, and a vinyl group in the side chain. A/B = 0.405

Pressure-sensitive adhesive 3: A pressure-sensitive adhesive in which the pressure-sensitive adhesive base resin is an acrylic-based polymer containing a structural unit derived from 2 ethylhexyl acrylate and butyl acrylate as the main component and having a hydroxy group and a carboxyl group in the side chain but no reactive double bond. A/B = 0.138

Pressure-sensitive adhesive 4: A pressure-sensitive adhesive in which the pressure-sensitive adhesive base resin is an acrylic-based polymer containing a butyl acrylate-derived structural unit as the main component and having a hydroxy group and a carboxyl group in the side chain but no reactive double bond. A/B = 0.138

* Note that 100 parts by mass of a diluted solution of the pressure-sensitive adhesive diluted with ethyl acetate to a solid content concentration of 33% by mass was further diluted with 120 parts by mass of propylene glycol monomethyl ether acetate (solvent) to prepare a coating liquid with a solid content concentration of 15% by mass, which was used in each of Examples and Comparative Examples.

[Example 1]

According to the formulation 1 shown in Table 1, the respective components were mixed using a planetary mixer at 25°C for 50 minutes to obtain a mixed composition. Subsequently, the mixed composition was injected into a mold set to have a thickness sufficiently larger than that of the heat conductive sheet, the magnetic field of 8T was applied in the thickness direction to orient the carbon fiber and flake graphite in the thickness direction, and then the curable silicone was primarily cured by heating at 80°C for 8 hours to obtain a block-shaped oriented formed product.

Next, the block-shaped oriented formed product was sliced into a sheet having a thickness of about 120 μm using a shear blade, thereby obtaining a sheet-like formed product in which the carbon fiber was exposed. Thereafter, the sheet-like formed product was heated at 150°C for 6 hours to perform secondary curing.

Subsequently, the sheet-like formed product was reciprocally polished 25 times with coarse sandpaper A (grain size: #800) having an average grain diameter (D50) of abrasive grains of 20 μm, and then was further reciprocally polished 10 times with coarse sandpaper B (grain size: #4000) having an average grain diameter (D50) of abrasive grains of 3 μm.

The coating liquid of the pressure-sensitive adhesive 1 was sprayed onto both surfaces of the obtained sheet-like formed product by adjusting the discharge amount so that the basis weight after drying was the amount listed in Table 1, and then dried at 50°C for 3 minutes, thereby obtaining a heat conductive sheet having an acrylic pressure-sensitive adhesive layer provided on both surfaces of the heat conductive layer. There were fine cells inside the heat conductive layer, and it was confirmed that the acrylic pressure-sensitive adhesive penetrated into the fine cells in the vicinity of both surfaces. Note that the filling rate of heat conductive filler in the heat conductive layer was 64.0% by volume, and the anisotropic filler was oriented in the thickness direction. The thickness of the heat conductive sheet was as listed in the table.

[Examples 2, 3, and 7]

The same procedure was carried out as in Example 1, except that the spray coating conditions were changed so that the basis weight of the acrylic pressure-sensitive adhesive layer after drying was as listed in Table 2.

[Example 4]

The same procedure was carried out as in Example 1, except that the type of the pressure-sensitive adhesive was changed as listed in Table 2, and the spray coating conditions were changed so that the basis weight of the acrylic pressure-sensitive adhesive layer after drying was as listed in Table 2.

[Example 5]

The same procedure was carried out as in Example 1, except that the block-shaped oriented formed product was sliced into a sheet having a thickness of about 80 μm.

[Example 6]

According to the formulation 3 shown in Table 1, the respective components were mixed using a planetary mixer at 25°C for 50 minutes to obtain a mixed composition. The mixed composition was applied to a base material film made of polyethylene terephthalate (PET) in one direction at 25°C using a bar coater as a coating applicator. The anisotropic filler was oriented so that the major axis direction was along the coating direction, the minor axis direction was in one direction of the sheet surface direction along a direction perpendicular to the coating direction. Next, the applied mixed composition was heated at 80°C for 8 hours to cure a liquid composition, thereby obtaining a primary sheet having a thickness of 2 mm.
Each surface of the obtained primary sheet was irradiated with VUV using a VUV irradiator (product name: Excimer MINI, manufactured by Hamamatsu Photonics K.K.) at room temperature (25°C) in the air with an amount of integrated light intensity of 20 mJ/cm$^2$ on the surface of the primary sheet. Next, the VUV-irradiated primary sheet was laminated in 100 sheets and pressed with a roller in an environment of 25°C at a pressure of 1.6 kgf/50 mm to obtain a laminated block. The laminated block obtained was sliced with a cutter blade in the direction parallel to the laminating direction and perpendicular to the direction which the major axis direction of the flake-like filler was along, to obtain a sheet-like formed product having a thickness of 2 mm of each unit layer and a sheet thickness of about 0.30 mm. In the sheet-like formed product, the anisotropic filler was oriented in the thickness direction. Thereafter, the sheet-like formed product was further heated at 150°C for 6 hours for secondary curing.
Then, a heat conductive sheet having an acrylic pressure-sensitive adhesive layer provided on both surfaces of the heat conductive layer was obtained in the same procedure as in Example 1, except that the spray coating conditions were changed so that the basis weight of the acrylic pressure-sensitive adhesive layer after drying was as listed in Table 2. Note that the filling rate of the heat conductive filler in the heat conductive layer was 70.2% by volume, and the anisotropic filler was oriented in the thickness direction.

[Example 8]

A heat conductive sheet having an acrylic pressure-sensitive adhesive layer provided on both surfaces of the heat conductive layer was obtained in the same procedure as in Example 1, except that the formulation of the mixed composition was changed to formulation 2 listed in Table 1, and the spray coating conditions were changed so that the basis weight of the acrylic pressure-sensitive adhesive layer after drying was as listed in Table 2. There were no fine cells inside the heat conductive layer, and it was not confirmed that the acrylic pressure-sensitive adhesive penetrated into the fine cells. Note that the filling rate of the heat conductive filler in the heat conductive layer was 59.9% by volume, and the anisotropic filler was oriented in the thickness direction.

[Comparative Example 1 and 2]

The same procedure was carried out as in Example 1, except that the type of the pressure-sensitive adhesive was changed as listed in Table 2, and the spray coating conditions were changed so that the basis weight of the acrylic pressure-sensitive adhesive layer after drying was as listed in Table 2.

[Comparative Example 3]

The same procedure was carried out as in Example 1, except that a pressure-sensitive adhesive coating liquid was not applied to the sheet-like formed product.

[Comparative Example 4]

The same procedure was carried out as in Example 8, except that the pressure-sensitive adhesive coating liquid was not applied to the sheet-like formed product.

[Comparative Example 5]

The same procedure was carried out as in Example 6, except that the pressure-sensitive adhesive coating liquid was not applied to the sheet-like formed product.

[Table 1]

| Components | Formulation 1 | Formulation 2 | Formulation 3 |
|---|---|---|---|
| Curable silicone | 100 | 100 | 100 |

(continued)

| Components | Formulation 1 | Formulation 2 | Formulation 3 |
|---|---|---|---|
| n-Decyltrimethoxysilane | 15 | | 21 |
| Aluminum oxide 1 | | 375 | 330 |
| Aluminum oxide 2 | 30 | | 307 |
| Aluminum | 243 | | |
| Graphitized carbon fiber | 160 | 120 | |
| Flake-like boron nitride | | | 112 |
| Flake graphite powder | 20 | 3 | |
| Sheet hardness (Type E) | 59 | 63 | 30 |

*Values of the respective components are expressed as parts by mass.
*Sheet hardness refers to a value measured for a cured product obtained from the formulation 1, 2, or 3 in each of Examples and Comparative Examples.

[Table 2]

| | | | Example 1 | Example 2 | Example 3 | Example 4 | Example 5 | Example 6 | Example 7 | Example 8 | Comparative Example 1 | Comparative Example 2 | Comparative Example 3 | Comparative Example 4 | Comparative Example 5 |
|---|---|---|---|---|---|---|---|---|---|---|---|---|---|---|---|
| Heat conductive layer | | | Formulation 1 | Formulation 1 | Formulation 1 | Formulation 1 | Formulation 1 | Formulation 3 | Formulation 1 | Formulation 2 | Formulation 1 | Formulation 1 | Formulation 1 | Formulation 2 | Formulation 3 |
| Basis weight | | mg/cm² | 0.36 | 0.32 | 0.43 | 0.32 | 0.36 | 0.43 | 0.87 | 0.43 | 0.73 | 0.53 | | | |
| Type of pressure-sensitive adhesive | | | Pressure-sensitive adhesive 1 | Pressure-sensitive adhesive 1 | Pressure-sensitive adhesive 1 | Pressure-sensitive adhesive 2 | Pressure-sensitive adhesive 1 | Pressure-sensitive adhesive 1 | Pressure-sensitive adhesive 1 | Pressure-sensitive adhesive 1 | Pressure-sensitive adhesive 3 | Pressure-sensitive adhesive 4 | No pressure-sensitive adhesive | No pressure-sensitive adhesive | No pressure-sensitive adhesive |
| Permeated or not | | | Permeated | Permeated | Permeated | Permeated | Permeated | Permeated | Permeated | Not | Permeated | Permeated | - | - | - |
| Surface roughness | Sa | μm | 3.6 | 3.6 | 3.3 | 3.5 | 4.3 | 11.2 | 3.3 | 5.1 | 3.3 | 4.6 | 4.3 | 5.4 | 9.8 |
| Initial sheet thickness | | μm | 130 | 129 | 133 | 142 | 78 | 270 | 137 | 125 | 136 | 130 | 135 | 125 | 267 |
| Thermal resistance (°C·cm²/W) | | 10psi | 0.186 | 0.21 | 0.168 | 0.138 | 0.183 | 0.527 | 0.231 | 0.406 | 0.272 | 0.250 | 0.162 | 0.274 | 0.509 |
| | | 20psi | 0.146 | 0.143 | 0.129 | 0.118 | 0.146 | 0.475 | 0.198 | 0.322 | 0.187 | 0.198 | 0.135 | 0.206 | 0.443 |
| | | 30psi | 0.118 | 0.113 | 0.109 | 0.103 | 0.117 | 0.441 | 0.177 | 0.246 | 0.154 | 0.165 | 0.118 | 0.171 | 0.402 |
| | | 40psi | 0.105 | 0.098 | 0.099 | 0.097 | 0.098 | 0.413 | 0.163 | 0.194 | 0.135 | 0.146 | 0.107 | 0.142 | 0.37 |
| Rate of change in thermal resistance | Blank ratio | 20psi | 108% | 106% | 96% | 87% | 107% | 107% | 147% | 156% | 139% | 147% | - | - | - |

24

| | | | Example 1 | Example 2 | Example 3 | Example 4 | Example 5 | Example 6 | Example 7 | Example 8 | Comparative Example 1 | Comparative Example 2 | Comparative Example 3 | Comparative Example 4 | Comparative Example 5 |
|---|---|---|---|---|---|---|---|---|---|---|---|---|---|---|---|
| Die shear strength (MPa) | No reflow proceeded | 25°C | 0.082 | 0.092 | 0.131 | 0.054 | 0.065 | 0.115 1b | 0.271 | 0.170 | 0.219 | 0.131 | Unmeasurable | Unmeasurable | Unmeasurable |
| | | 80°C | 0.074 | 0.085 | 0.051 | 0.022 | 0.033 | 0.127 | 0.141 | 0.032 | 0.144 | 0.127 | Unmeasurable | Unmeasurable | Unmeasurable |
| | | 150°C | 0.029 | 0.052 | 0.042 | 0.021 | 0.030 | 0.084 | 0.108 | 0.005 | 0.073 | 0.033 | Unmeasurable | Unmeasurable | Unmeasurable |
| | Reflow proceeded (250°C, 3min) | 25°C | 0.090 | 0.116 | 0.112 | 0.122 | 0.090 | 0.108 | 0.382 | 0.221 | 0.095 | 0.096 | - | - | - |
| | | 80°C | 0.078 | 0.091 | 0.120 | 0.098 | 0.078 | 0.088 | 0.326 | 0.160 | 0.081 | 0.094 | - | - | - |
| | | 150°C | 0.081 | 0.086 | 0.118 | 0.049 | 0.064 | 0.089 | 0.337 | 0.135 | 0.071 | 0.044 | - | - | - |
| Rate of change in die shear strength (%) | 25°C, heated/25°C, unheated | | 110% | 126% | 85% | 227% | 138% | 94% | 141% | 130% | 43% | 73% | - | - | - |
| | 80°C, heated/25°C, unheated | | 95% | 99% | 92% | 182% | 120% | 76% | 120% | 94% | 37% | 72% | - | - | - |
| | 150°C, heated/25°C unheated | | 99% | 94% | 90% | 91% | 99% | 77% | 124% | 79% | 32% | 34% | - | - | - |

*In Comparative Example 3, the die shear strength could not be measured because the heat conductive sheet could not tightly adhere to the silicon die or nickel-plated copper plate.

EP 4 693 396 A1

In Examples described above, when the acrylic pressure-sensitive adhesive layer having a reactive double bond was provided on the surface of the heat conductive sheet, die shear strength had been improved and thus adhesion to the adherend was improved. In addition, high die shear strength was maintained even when the heat-conducting sheet was heated at a high temperature of, for example, about 250°C in a state of being tightly adhered to the adherend, thus preventing the tightly adhered heat-conducting sheet from peeling off or the like even after a reflow process or the like. These results were similar when die shear strength was measured at 80°C and 150°C, assuming the use environment.

Meanwhile, in also Comparative Examples 1 and 2,when the acrylic pressure-sensitive adhesive layer was provided on the surface of the heat conductive sheet, die shear strength had been improved. However, since the acrylic pressure-sensitive adhesive layer does not have a reactive double bond, there is concern that the heat conductive sheet might peel in the reflow process or the like due to a failure to maintain high die shear strength when heated to a high temperature (250°C) in a state of being tightly adhered to the adherend. The die shear strength could not be improved in Comparative Examples 3 to 5 because the acrylic pressure-sensitive adhesive layer was not provided on the surface of the heat conductive sheet.

**Claims**

1.   A heat conductive sheet comprising a heat conductive layer comprising a polymer matrix and a heat conductive filler, and an acrylic pressure-sensitive adhesive layer provided on a surface of the heat conductive layer, the acrylic pressure-sensitive adhesive layer comprising a reactive double bond.

2.   The heat conductive sheet according to claim 1, wherein an intensity ratio A/B of a peak intensity A of C=C stretching vibration to a peak intensity B of C=O stretching vibration is 0.2 or more in a Raman spectrum of the acrylic pressure-sensitive adhesive layer.

3.   The heat conductive sheet according to claim 1 or 2, wherein the polymer matrix is organopolysiloxane.

4.   The heat conductive sheet according to claim 1 or 2, wherein the heat conductive layer comprises an anisotropic filler oriented in a thickness direction of the heat conductive layer.

5.   The heat conductive sheet according to claim 1 or 2, wherein the surface of the heat conductive layer is a slice surface.

6.   The heat conductive sheet according to any one of claims 1 to 5, wherein the acrylic pressure-sensitive adhesive layer permeates into the heat conductive layer.

7.   A method for producing a heat conductive sheet, comprising the steps of:

   mixing at least a curable polymer composition and a heat conductive filler to obtain a mixed composition;
   curing the mixed composition by heating to obtain a cured product; and
   applying a pressure-sensitive adhesive to a surface of the cured product,
   the pressure-sensitive adhesive being an acrylic pressure-sensitive adhesive comprising a reactive double bond.

8.   The method for producing a heat conductive sheet according to claim 7, comprising heating the mixed composition to obtain a formed product, slicing the formed product, and forming the cured product into a sheet shape.

9.   The method for producing a heat conductive sheet according to claim 7 or 8, wherein a compatible substance is further mixed in addition to the curable polymer composition and the heat conductive filler to obtain the mixed composition, and at least a part of the compatible substance is volatilized by the heating.

10.   The method for producing a heat conductive sheet according to claim 7 or 8, comprising allowing the applied pressure-sensitive adhesive to permeate into the cured product.

11.   An adhesion method comprising: a tight adhesion step of disposing the heat conductive sheet according to claim 1 or 2 between a semiconductor chip and a heat spreader to tightly adhere the sheet thereto; and an adhesion step of bonding the semiconductor chip and the heat spreader, which are heated to 200°C or more after the tight adhesion step.

12.   The adhesion method according to claim 11, wherein in the tight adhesion step, the heat conductive sheet is sandwiched between the semiconductor chip and the heat spreader and then pressurized at 50°C or more and 200°C or less to be tightly adhered.

13. The adhesion method according to claim 11 or 12, wherein the adhesion step is performed in a non-pressurized state.

14. Use of a heat conductive sheet for adhering a semiconductor chip and a heat spreader in a reflow process, the heat conductive sheet comprising a heat conductive layer comprising a polymer matrix and a heat conductive filler, and an acrylic pressure-sensitive adhesive layer provided on a surface of the heat conductive layer,
the acrylic pressure-sensitive adhesive layer comprising a reactive double bond.

Fig. 1

Fig. 2

## INTERNATIONAL SEARCH REPORT

International application No.

**PCT/JP2024/013141**

### A. CLASSIFICATION OF SUBJECT MATTER

*H01L 23/36*(2006.01)i; *C08K 3/013*(2018.01)i; *C08L 83/04*(2006.01)i; *H05K 7/20*(2006.01)i
FI:  H01L23/36 D; H05K7/20 F; C08L83/04; C08K3/013

According to International Patent Classification (IPC) or to both national classification and IPC

### B. FIELDS SEARCHED

Minimum documentation searched (classification system followed by classification symbols)

H01L23/36; C08K3/013; C08L83/04; H05K7/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2012-109312 A (HITACHI CHEMICAL CO., LTD.) 07 June 2012 (2012-06-07) paragraphs [0002]-[0003], [0025]-[0029], [0056], fig. 1 | 1, 3-14 |
| A | | 2 |
| Y | JP 2002-194232 A (SEKISUI CHEMICAL CO., LTD.) 10 July 2002 (2002-07-10) paragraphs [0023]-[0030] | 1, 3-14 |
| A | | 2 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **03 June 2024** | **18 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/013141**

| Patent document cited in search report | | | Publication date (day/month/year) | Patent family member(s) | Publication date (day/month/year) |
|---|---|---|---|---|---|
| JP | 2012-109312 | A | 07 June 2012 | (Family: none) | |
| JP | 2002-194232 | A | 10 July 2002 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7067571 B